(19) Europäisches Patentamt
European Patent Office
Office européen des brevets

(11) EP 0 760 473 B1

(12) **EUROPEAN PATENT SPECIFICATION**

(45) Date of publication and mention of the grant of the patent:
**29.10.2003 Bulletin 2003/44**

(51) Int Cl.[7]: **G01N 17/02**

(21) Application number: **96113423.6**

(22) Date of filing: **21.08.1996**

(54) **Metal surface state evaluation method and semiconductor device production method**

Metalloberflächenzustandsevaluationsmethode und Halbleiterproduktionsmethode

Méthode pour l'évaluation des surfaces des métaux et méthode pour la production des semi-conducteurs

(84) Designated Contracting States:
**DE FR GB**

(30) Priority: **24.08.1995 JP 21582995**
**12.03.1996 JP 5457796**

(43) Date of publication of application:
**05.03.1997 Bulletin 1997/10**

(73) Proprietor: **MATSUSHITA ELECTRIC INDUSTRIAL CO., LTD.**
**Kadoma-shi, Osaka 571-0050 (JP)**

(72) Inventors:
- **Kawaguchi, Akemi**
**Neyagawa-shi, Osaka 572 (JP)**
- **Aoi, Nobuo**
**Nishinomiya-shi, Hyogo 662 (JP)**

(74) Representative: **Grünecker, Kinkeldey, Stockmair & Schwanhäusser Anwaltssozietät**
**Maximilianstrasse 58**
**80538 München (DE)**

(56) References cited:
**EP-A- 0 591 802**
**US-A- 4 338 157**
**US-A- 4 511 844**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 760 473 B1

## Description

### Background of the Invention

The present invention relates to a method of evaluating, in an in-line, nondestructive and quantitative manner in a short period of time, the surface state and corrosive properties of metal to be used, for example, for wiring on a semiconductor substrate, and also relates to a semiconductor device production method using the first-mentioned method.

The surface state of metal exerts a great influence upon corrosion thereof. For example, an aluminum layer used for wiring on a semiconductor substrate is improved in corrosion resistance by a natural oxide layer finely formed on the surface thereof.

In an aluminum layer, a difference in potential is formed between aluminum and copper added in several percents to the aluminum for improving the resistance to electromigration of the aluminum layer. Accordingly, as the segregation amount of copper on the surface of the aluminum layer is greater, much local cells are formed, causing the aluminum layer to be readily corroded.

Accordingly, to know the surface state of metal is led to evaluation of the corrosion resistance thereof.

As the metal surface state evaluation method, there is proposed a physical analysis of which examples include a direct observation method using TEM (Transmission Electron Microscope), a layer thickness measurement method using AES (Auger Electron Spectroscopy), a bond-state evaluation method using XPS (X-ray Photo-emission Spectroscopy), a segregation amount measurement method using a plane SIMS (Secondary Ion Mass Spectrometer) and the like.

According to each of the conventional metal surface state evaluation methods above-mentioned, however, metal to be evaluated is cut to form a sample and an electron beam, X-rays or ions are then incident upon the sample for measurement. Accordingly, each of the methods above-mentioned is a destructive analysis method and takes time for sample preparation and measurement, and is therefore disadvantageous in that it is difficult to use such a method as an in-line analysis method (analysis incorporated in a semiconductor device mass-production line). Further, each of the conventional metal surface state evaluation methods above-mentioned-is disadvantageous in that no quantitative evaluation can be made on corrosive properties.

EP-A-0 591 802 discloses a method of measuring the corrosion degree of a metal, comprising the steps of:

- immersing a first electrode made of said metal and a counter electrode connected to said first electrode in an electrolytic solution;
- applying a voltage changing in an anodic direction to said first electrode which is at an initial potential when immersed in the electrolytic solution, so that the potential of said first electrode is raised up to a passive state region, and kept at said region;
- stepwise changing the potential of said first electrode up to a predetermined potential which lies between said initial potential and said passive state potential;
- measuring the time in which the value of the current flowing between said first electrode and the counter electrode reaches a constant value; and
- determining the corrosion degree of the material from said measured time.

### Summary of the Invention

To overcome the conventional problems above-mentioned, the present invention is proposed with the object of evaluating, in an in-line manner in a short period of time, the surface state of a metal for corrosion resistance, surface smoothness, the pitting corrosion resistance of a surface layer, the segregation amount or concentration of trace metal contained in the metal, the grain size or grain boundary length of the metal and the like, such evaluation being quantitatively made without a specimen of the metal being broken.

To achieve the object above-mentioned, a metal surface state evaluation method according to the present invention comprises: a solution contacting step of bringing a metal surface into contact with a solution containing ions to corrode the metal; a metal corroding step of applying, to the solution, each of a plurality of constant electric currents respectively having different current values, causing the metal surface to be corroded by the solution; an electrode potential measuring step of measuring, at each of the electric currents, the electrode potential of the metal surface which is being corroded by the solution; a change ratio calculating step of calculating, based on the electrode potential at each of the electric currents, a ratio of changes in time of pitting corrosion to changes in current value; and a dissolving speed measuring step of measuring, based on the change ratio, a speed at which an oxide layer formed on the metal surface is dissolved thereby evaluating the smoothness and/or pitting corrosion resistance of said metal surface.

According to the first metal surface state evaluation method, metal is subjected, as contacted with a solution

containing ions to corrode the metal, to constant-current electrolysis, and the electrode potential of the metal is measured. Based on the electrode potential thus measured, there is calculated a ratio of changes in time of pitting corrosion to changes in current value. Using the fact that the slope of a graphic line illustrating the relationship between the ratio of changes in time of pitting corrosion and the concentration of the solution, shows a dissolving speed of an oxide layer formed on the metal surface, the dissolving speed of the oxide layer can be measured based on the ratio of changes in time of pitting corrosion. Accordingly, based on the relationship between the ratio of changes in time of pitting corrosion of the metal to changes in current value and the dissolving speed of the oxide layer formed on the metal surface, the oxide layer dissolving speed can be measured in an in-line manner in a short period of time without the metal being broken.

According to the arrangement above-mentioned, based on the relationship between oxide layer dissolving speed and metal surface smoothness, the metal surface smoothness can quantitatively be evaluated in an in-line manner in a short period of time without the metal being broken.

According to the arrangement above-mentioned, based on the relationship between oxide layer dissolving speed and pitting corrosion resistance of oxide layer, the pitting corrosion resistance of the oxide layer can quantitatively be evaluated in an in-line manner in a short period of time without the metal being broken.

A metal surface state evaluation method according to the present invention may further comprise: a pitting-corrosion time calculating step of calculating, based on the electrode potential at each of the current values, a relationship between current value and time of pitting corrosion; a critical current value calculating step of calculating, based on the relationship between current value and time of pitting corrosion, a critical current value which is the minimum current value at which pitting corrosion starts occurring; and a pitting-corrosion property evaluating step of evaluating, based on the critical current value and the change ratio, the pitting corrosion property of the metal.

Preferably, the metal surface state evaluation method further comprises a grain size or grain boundary length evaluating step of evaluating the grain size or grain boundary length of the metal based on the critical current value. According to the arrangement above-mentioned, based on the relationship between the critical current value of the metal and the grain size or grain boundary length of the metal, the grain size or grain boundary length of the metal can quantitatively be evaluated in an in-line manner in a short period of time without the metal being broken.

Based on the relationship between current value and time of pitting corrosion, the critical current value of the metal surface is calculated. Thus, there can be evaluated (i) the smoothness of the metal surface and the pitting corrosion resistance of the oxide layer formed on the metal surface, each of which relates to the ratio of changes in time of pitting corrosion, and (ii) the resistance to pitting corrosion of the metal surface, the segregation amount or concentration of contained trace metal, and the grain size or grain boundary length of Al, each of which relates to the critical current value. Accordingly, based on the change ratio and the critical current value, the corrosion resistance of the metal surface can quantitatively be evaluated in an in-line manner in a short period of time without the metal surface being broken.

A first semiconductor device production method comprises: a metallic thin layer forming step of forming a metallic thin layer on a semiconductor substrate under predetermined deposit conditions; a solution contacting step of bringing the metallic thin layer into contact with a solution containing ions to corrode the metallic thin layer; a metallic thin layer corroding step of applying, to the solution, each of a plurality of constant electric currents respectively having different current values, causing the metallic thin layer to be corroded by the solution; an electrode potential measuring step of measuring, at each of the electric currents, the electrode potential of the metallic thin layer which is being corroded by the solution; a pitting-corrosion time calculating step of calculating, based on the electrode potential at each of the current values, a relationship between current value and time of pitting corrosion; a change ratio calculating step of calculating, based on the electrode potential at each of the electric currents, a ratio of changes in time of pitting corrosion to changes in current value; a critical current value calculating step of calculating, based on the relationship between current value and time of pitting corrosion, a critical current value which is the minimum current value at which pitting corrosion starts occurring; and a deposit condition judging step of evaluating the surface state of the metallic thin layer based on the change ratio and the critical current value, and judging, based on the evaluation thus made, whether or not the predetermined deposit conditions at the metallic thin layer forming step are suitable.

According to the first semiconductor device production method, a metallic thin layer formed on a semiconductor substrate under predetermined deposit conditions, is subjected, as contacted with a solution containing ions to corrode the metallic thin layer, to constant-current electrolysis, and the electrode potential of the metallic thin layer is measured. Based on the electrode potential thus measured, there are calculated the relationship between current value and time of pitting corrosion and a ratio of changes in time of pitting corrosion to changes in current value. Based on the relationship between current value and time of pitting corrosion, the critical current value of the metallic thin layer is calculated. Thus, there can be evaluated (i) the surface smoothness of the metallic thin layer and the pitting corrosion resistance of an oxide layer formed on the surface of the metallic thin layer, each of which relates to the ratio of changes in time of pitting corrosion, and (ii) the resistance to pitting corrosion of the metallic thin layer, the segregation amount or concentration of contained trace metal, and the grain size or grain boundary length of Al, each of which

relates to the critical current value. Accordingly, the metallic thin layer can be evaluated for surface state, and based on the evaluation thus made, a judgement can be made of whether or not the predetermined deposit conditions at the metallic thin layer forming process are suitable. Accordingly, the surface state of the metallic thin layer formed on a semiconductor substrate under predetermined deposit conditions can be evaluated based on the ratio of changes in time of pitting corrosion to changes in current value and on the critical current value. Based on the evaluation thus made, a judgement can be made of whether or not the predetermined deposit conditions used in the metallic thin layer forming process are suitable. Thus, the metallic thin layer deposit conditions can be determined in a short period of time.

A second semiconductor device production method comprises: a step of forming metallic wiring on a semiconductor substrate; a step of forming an oxide layer on the metallic wiring; a solution contacting step of bringing the metallic wiring having the oxide layer formed thereon, into contact with a solution containing ions to corrode the metallic wiring; a metallic wiring corroding step of applying, to the solution, each of a plurality of constant electric currents respectively having different current values, causing the metallic wiring to be corroded by the solution; an electrode potential measuring step of measuring, at each of the electric currents, the electrode potential of the metallic wiring which is being corroded by the solution; a change ratio calculating step of calculating, based on the electrode potential at each of the electric currents, a ratio of changes in time of pitting corrosion to changes in current value; a corrosion resistance evaluating step of evaluating the corrosion resistance of the oxide layer based on the change ratio; and an oxide layer judging step of comparing the corrosion resistance of the oxide layer with a predetermined standard, whereby the oxide layer is removed and a new oxide layer is then formed when the corrosion resistance of the first-mentioned oxide layer does not satisfy the predetermined standard, or the process at the subsequent step is executed on the semiconductor substrate having the oxide layer formed thereon when the corrosion resistance of the oxide layer satisfies the predetermined standard.

According to the second semiconductor device production method, metallic wiring having an oxide layer formed on the surface thereof is subjected, as contacted with a solution containing ions to corrode the metallic wiring, to constant-current electrolysis, and the electrode potential of the metallic wiring is measured. Based on the electrode potential thus measured, there is calculated a ratio of changes in time of pitting corrosion to changes in current value. Accordingly, there can be evaluated the pitting corrosion resistance of the oxide layer which relates to the ratio of changes in time of pitting corrosion. Thus, the oxide layer can be evaluated for corrosion resistance. Accordingly, in a metallic wiring having an oxide layer formed on the surface thereof, the corrosion resistance of the oxide layer can be evaluated based on the relationship between (i) the ratio of changes in time of pitting corrosion to changes in current value and (ii) the pitting corrosion resistance of the oxide layer. Based on the evaluation thus made, the corrosion resistance of the oxide layer is compared with a predetermined standard. Based on the result of such comparison, a judgement can be made of whether or not the oxide layer is good. Such a judgment can be made in an in-line manner in a short period of time without the metallic wiring cut. Further, an oxide layer which does not satisfy the predetermined standard, can be modified. This greatly contributes to improvements in production yield of semiconductor devices.

Brief Description of the Drawings

Fig. 1 is a schematic view of a measurement apparatus to be used in a metal surface state evaluation method according to a first embodiment of the present invention;

Fig. 2 is a detailed view of the measurement apparatus to be used in the metal surface state evaluation method according to the first embodiment of the present invention;

Each of Fig. 3 (a), (b), Fig. 4 (a), (b) and Fig. 5 is a view illustrating changes in electrode potential with the passage of time when constant-current electrolysis is conducted in hydrochloric acid according to the metal surface state evaluation method in accordance with the first embodiment of the present invention;

Fig. 6 is a characteristic view illustrating the relationship between time of pitting corrosion and electric current density when constant-current electrolysis is conducted in each of hydrochloric acids respectively presenting different concentrations, in the metal surface state evaluation method according to the first embodiment of the present invention;

Each of Fig. 7 (a) and (b) is a section view illustrating courses of metal corrosion in the metal surface state evaluation method according to the first embodiment of the present invention;

Fig. 8 is a characteristic view illustrating the relationship between the concentration of hydrochloric acid and graphic slope obtained through constant-current electrolysis in the metal surface state evaluation method according to the first embodiment of the present invention;

Fig. 9 is a view illustrating a critical electric current value in the metal surface state evaluation method according to the first embodiment of the present invention;

Fig. 10 is a characteristic view illustrating the relationship between time of pitting corrosion and electric current

density when each of AlCu metals having different grain sizes is subjected to constant-current electrolysis in hydrochloric acid, in the metal surface state evaluation method according to the first embodiment of the present invention;

Fig. 11 is a general view of a measurement apparatus to be used in a metal surface state evaluation method according to a second embodiment of the present invention;

Fig. 12 is a detailed view of the measurement apparatus to be used in the metal surface state evaluation method according to the second embodiment of the present invention;

Fig. 13 is a flow chart of the steps of a semiconductor device production method;

Fig. 14 is a schematic view of a measurement apparatus used in a metal surface state evaluation method according to the present invention;

Fig. 15 is a detailed view of the measurement apparatus used in the metal surface state evaluation method according to the present invention;

Fig. 16 is a view illustrating changes in corrosion current with the passage of time when constant-potential electrolysis is conducted in hydrochloric acid, in the metal surface state evaluation method according to the present invention;

Fig. 17 is a general view of a measurement apparatus used in a metal surface state evaluation method according to the present invention; and

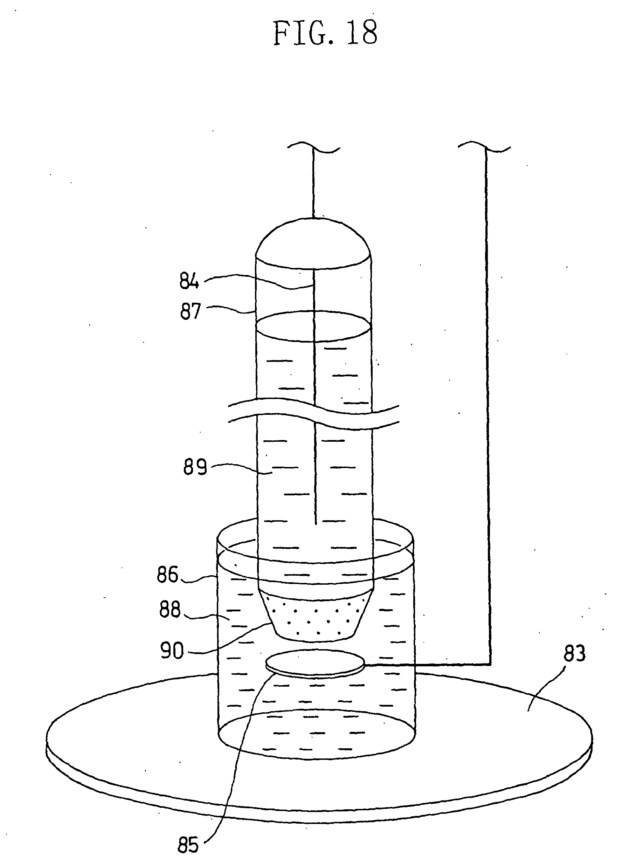

Fig. 18 is a detailed view of the measurement apparatus used in the metal surface state evaluation method according to the present invention.

Detailed Description of the Invention

(First Embodiment)

With reference to Figs. 1 and 2, the following description will discuss a measurement apparatus to be used in a metal surface state evaluation method according to a first embodiment of the present invention.

Fig. 1 shows a schematic arrangement of the measurement apparatus, while Fig. 2 shows in detail the same. This measurement apparatus is arranged to measure, at a constant electric current in a solution, the electrode potential of an Al alloy layer which is a metallic thin layer for wiring (metallic wiring layer) on a semiconductor wafer serving as a semiconductor substrate.

Shown in Figs. 1 and 2 are a galvanostat 11 for measuring a natural electrode potential, a recorder 12 for recording changes in potential with the passage of time, and a semiconductor wafer 13 on which there is deposited a sample to be measured or an Al alloy layer serving as the metallic wiring layer. Also shown in Figs. 1 and- 2 are a reference electrode 14 made of Ag/AgCl, a counter electrode 15 made of Pt, and connection wiring lines 16, 17, 18 for respectively connecting the semiconductor wafer 13, the reference electrode 14 and the counter electrode 15 to the galvanostat 11. By immersing the semiconductor wafer 13, the reference electrode 14 and the counter electrode 15 in a measurement cell 19 filled with a solution, changes in electrode potential with the passage of time can be measured. Provision is made such that, when applied, an electric current flows from the galvanostat 11 to the semiconductor wafer 13 through the counter electrode 15, and that the galvanostat 11 reads a difference in potential between the reference electrode 14 and the semiconductor wafer 13.

With reference to Figs. 3 to 10, the following description will discuss a metal surface state evaluation method of conducting an electrical chemical evaluation using the measurement apparatus having the arrangement abovementioned.

Figs. 3 to 5 show changes in potential with the passage of time when AlSiCu thin layers were subjected to constant-current electrolysis in a 1N (normality)-hydrochloric acid solution using constant electric currents respectively having different current values (current density values).

As the solution, a hydrochloric acid solution was used because chlorine ions are liable to corrode aluminum. However, such a solution of hydrochloric acid is not necessarily required as far as the solution generates halogen ions.

From the changes with the passage of time in Figs. 3 to 5, there can be read, at the respective constant current values (constant current density values), periods of time during which aluminum oxide layers formed on the AlSiCu thin layers were pitted and corroded by a cathodic action of Cu in the hydrochloric acid. In Figs. 3 to 5, the time zones of 0 to $T_1 \sim T_5$ where the values of potential fluctuate, are times of pitting corrosion during which the aluminum oxide layers are being pitted and corroded.

After the passage of times of $T_1 \sim T_5$, a number of corroded pits are generated and the aluminum oxide layers finally disappear such that the AlSiCu thin layers are evenly corroded in their entirety. That is, the whole surfaces are corroded. In Figs. 3 to 5, the time zones after $T_1$ to $T_5$ where the values of potential are monotonously lowered, are times of whole surface corrosion during which the whole surfaces are being corroded. It is therefore possible to clearly distinguish the times of pitting corrosion of 0 to $T_1 \sim T_5$ during which the potential values fluctuate, from the time of

whole surface corrosion during which the potentials are monotonously lowered.

The following description will discuss a mechanism of generating pitting corrosion with reference to Fig. 7 (a) and (b).

Fig. 7 (a) shows a state where an aluminum oxide layer 32 as an oxide layer is formed on the surface of an AlSiCu alloy 31. Copper 34 is segregated on a boundary of aluminum crystal grains 33, and a copper oxide layer 35 is formed on the surface of the copper 34. When the sample shown in Fig. 7 (a) is immersed in a hydrochloric acid solution and a constant electric current is let flow therein, the aluminum oxide layer 32 and the copper oxide layer 35 dissolve. Accordingly, as shown in Fig. 7 (b), the copper 34 is exposed to the outside, causing the same to act as a cathode in the hydrochloric acid. In such a state, there is formed a difference in potential between the hydrochloric acid and the AlSiCu alloy 31 such that an electric field acts on the aluminum oxide layer 32. This results in formation of an opening 36. Such a phenomenon that the opening 36 is formed in the aluminum oxide layer 32, refers to pitting corrosion.

Fig. 6 shows the data obtained by subjecting wiring AlSiCu thin layers immediately after formed by sputtering, to constant-current electrolysis in hydrochloric acids respectively representing different concentrations with the use of constant electric currents respectively having different current values. In Fig. 6, the data are shown in the form of a graph in which the axis of ordinate represents the time of pitting corrosion measured in the manner mentioned earlier and the axis of abscissa represents, in the form of a logarithm, the current density of an applied constant electric current. In Fig. 6, graphic lines (a), (b) and (c) show relationships between time of pitting corrosion and current density (current value), as obtained through constant-current electrolysis in a 0.1N-hydrochloric acid, a 1N-hydrochloric acid and a 2N-hydrochloric acid, respectively.

From Fig. 6 showing the data obtained by conducting constant-current electrolysis with the hydrochloric acid changed in concentration, it is understood that the dependency of the time of pitting corrosion on the current value varies with changes in concentration of the hydrochloric acid. More specifically, as the hydrochloric acid is higher in concentration or as the dissolving speed is faster, the dependency of the time of pitting corrosion on the current value is lowered and the slope of a graphic line in Fig. 6 is smaller. That is, when the hydrochloric acid is high in concentration, pitting corrosion due to copper is not predominating. Thus, even though the current value is increased, the time of pitting corrosion is not increased. In this connection, there is established a first relationship that, in a metallic oxide, as the slope of a graphic line indicative of the relationship between current value and time of pitting corrosion of the oxide is smaller, the oxide is more liable to be corroded in a solution irrespectively of the current value. Accordingly, by obtaining the slope of graphic line above-mentioned, the corrosion resistance of a metallic oxide or the pitting corrosion of an oxide layer on the metal surface with respect to corrosion can be evaluated.

In Fig. 8, the axis of ordinate represents the slope of each of the graphic lines (a), (b) and (c) in Fig. 6 indicative of the relationship between time of pitting corrosion and current density (current value), and the axis of abscissa represents the concentration of hydrochloric acid shown in the form of a logarithm. In Fig. 8, there is obtained a straight line of which slope with respect to the concentration of hydrochloric acid is -5.3.

On the other hand, the dissolving, by hydrochloric acid, of the aluminum oxide layer ($Al_2O_3$) serving as the oxide layer on the AlSiCu thin layer, can be expressed in the following formula (1):

$$Al_2O_3 + 6HCl \xrightarrow{k} 2AlCl_3 + 3H_2O \quad \cdots\cdots (1)$$

wherein k is a reaction speed constant.

As shown in the following formula (2), the dissolving speed of $Al_2O_3$ is proportional to the sixth power of the concentration of hydrochloric acid:

$$-d\,[Al_2O_3]/dt = k\,[Hcl]^6 \quad (2)$$

On the other hand, the following two points are understood from the graph in Fig. 8.

Firstly, it is understood that, with an increase in concentration of hydrochloric acid, the ratio of changes in time of pitting corrosion to changes in current density or current value (the value of "graphic slope" on the axis of ordinate in Fig. 8) becomes smaller due to a negative sign of the graphic line in Fig. 8 and the aluminum oxide layer is more readily corroded.

Secondly, it is understood that, since the slope of the graphic line in Fig. 8 is -5.3, the ratio of changes in time of pitting corrosion to changes in current density is proportional to the -5.3th power of the concentration of hydrochloric

acid. It is understood that, with the meaning of the negative sign taken into consideration, the corrodibility of the aluminum oxide layer is proportional to the 5.3th power of the concentration of hydrochloric acid.

The exponent of the concentration of hydrochloric acid indicative of the dissolving speed of the aluminum oxide layer ($Al_2O_3$), is equal to the value of the slope of the graphic line in Fig. 8 or the value represented by the formula (2). The slope in Fig. 8 and the value of the formula (2) are respectively equal to 5.3 and 6, which are approximate to each other. In this connection, the slope value of the graphic line in Fig. 8 refers to the dissolving speed of the aluminum oxide layer ($Al_2O_3$).

More specifically, there are obtained the slopes of graphic lines, in Fig. 6, each indicative of the relationship between time of pitting corrosion and current density as obtained by a constant-current electrolysis method, and the slopes of graphic lines thus obtained are plotted with respect to the concentrations of hydrochloric acids, thus providing the graphic line in Fig. 8. A slope value of the graphic line in Fig. 8 is indicative of the dissolving speed of an oxide layer formed on the metal surface. Accordingly, by obtaining a slope value of the graphic line in Fig. 8, the dissolving speed of the oxide layer can be measured.

As a general nature, there is a second relationship that, as the metal surface is lower in smoothness, the dissolving speed is greater.

Thus, metal having a surface to be evaluated for state, is subjected to constant-current electrolysis in a solution, and the relationship between current value and time of pitting corrosion is measured. Based on the relationship thus measured, the dissolving speed of an oxide layer on the metal surface can be measured. Accordingly, there can be evaluated the smoothness and pitting corrosion resistance of the metal surface each of which relates to the dissolving speed of the oxide layer.

In Fig. 6, the graphic line (d) shows the relationship between current density (current value) and time of pitting corrosion as obtained by- subjecting an AlSiCu thin layer thermally treated for five minutes at a temperature of 450°C, to constant-current electrolysis in 0.1N-hydrochloric acid. As shown in Fig. 6, the slope of the graphic line (d) is substantially the same as that of the graphic line (a) showing such a relationship obtained from an AlSiCu thin layer which was immersed, immediately after sputtering, in 0.1N-hydrochloric acid. It is therefore understood that, even though the metal is thermally treated, the smoothness and pitting corrosion resistance of the metal surface undergo no change.

Next, there are obtained the critical current values (= $I_{crit}$) of an AlSiCu thin layer immediately after formed-by sputtering and an AlSiCu thin layer after a thermal treatment. As shown in Fig. 9, a critical current value refers to an X-intersect obtained by extending a graphic line indicative of the relationship between current value and time of pitting corrosion in the negative direction of the current value. That is, the critical current is a minimum current value at which pitting corrosion starts occurring. Accordingly, when the critical current value is small, this means that pitting corrosion readily occurs. Thus, by obtaining the critical current value, metal can be evaluated for pitting corrosion properties.

Here, using the graphic lines (a) and (d) in Fig. 6, the critical current values are obtained. The critical current value for the AlSiCu thin layer immediately after sputtering, is $1.2 \times 10^{-11}$(A/cm$^2$) from the graphic line (a), and the critical current value for the thermally treated AlSiCu thin layer is $2.7 \times 10^{-24}$(A/cm$^2$) from the graphic line (d). Thus, the critical current value for the thermally treated AlSiCu thin layer is reduced by 13 digits as compared with that for the AlSiCu thin layer immediately after sputtering. More specifically, when the thin layer is thermally treated, the amount of copper segregated at the grain boundary is increased, causing the layer to be readily pitted and corroded to lower the critical current value. Thus, the segregation amount or concentration of copper in the AlSiCu thin layer can be evaluated. That is, by obtaining the critical current value, the segregation amount or concentration of contained trace metal can be evaluated.

Fig. 10 shows the relationship between current density and time of pitting corrosion when AlCu thin layers of which grain sizes are different by 10 to 15 times from each other, were subjected to constant-current electrolysis. In Fig. 10, the graphic line (a) shows the relationship above-mentioned in an AlCu thin layer having a grain size of 2 to 3 μm, while the graphic line (b) shows the relationship above-mentioned in the AlCu thin layer having a grain size of 0.2 μm.

As apparent from Fig. 10, the critical current value for the AlCu thin layer having a grain size of 2 to 3 μm shown by the graphic line (a), is $1.4 \times 10^{-8}$(A/cm$^2$) and the critical current value for the AlCu thin layer having a grain size of 0.2 μm shown by the graphic line (b), is $1.4 \times 10^{-14}$(A/cm$^2$). Thus, the critical current value for an AlCu thin layer having a greater grain size, is greater than the critical current value of an AlCu thin layer having a smaller grain size. That is, as the grain size is greater, the grain boundary length is shorter and the amount of copper segregated on the grain boundary is reduced to restrain corrosion due to a local battery effect. Accordingly, by obtaining a critical current value, the grain boundary length or grain size of Al in the AlCu thin layer can be evaluated. More specifically, by obtaining a critical current value, the grain boundary length or grain size of Al can be evaluated.

Thus, metal having a surface to be evaluated for state, is subjected to constant-current electrolysis in a solution, the electrode potential is measured and the relationship between current value and time of pitting corrosion is measured. Based on the relationship thus measured, the critical current value of the metal can be obtained. From the

critical current value thus obtained, the metal can be evaluated for resistance to pitting corrosion, the segregation amount or concentration of contained trace metal and the grain boundary length or grain size of Al.

Accordingly, metal having a surface to be evaluated for state, is subjected to constant-current electrolysis in a solution, the electrode potential is measured, the ratio of changes in time of pitting corrosion to changes in applied current value is obtained based on changes in electrode potential with the passage of time, the dissolving speed of the oxide layer on the metal surface is measured based on the change ratio thus obtained, and the smoothness and pitting corrosion resistance of the metal surface can be evaluated based on the dissolving speed thus measured. Further, based on the relationship between applied current value and time of pitting corrosion, the critical current value of the metal is calculated, and based on the critical current value thus calculated, the metal can be evaluated for resistance to pitting corrosion, the segregation amount or concentration of contained trace metal, the grain boundary length or grain size of the Al. Thus, the resistance to corrosion of the metal can be evaluated.

According to the first embodiment, a sample to be measured is subjected to constant-current electrolysis in hydrochloric acid, the electrode potential is measured, and changes in electrode potential with the passage of time are measured to obtain the relationship between current value and time of pitting corrosion. Based on the relationship thus obtained, the metal can be evaluated for surface smoothness, the pitting corrosion resistance of the metal surface, resistance to pitting corrosion, the segregation amount or concentration of contained trace metal, the grain boundary length or grain size of Al and the general corrosion resistance with these chemical and physical properties put together, such evaluation being made in an in-line manner in a short period of time without the metal broken.

Accordingly, any occurrence of corrosion of metal in a wiring forming process can be monitored in an in-line manner in a short period of time without the semiconductor wafer broken. This greatly contributes to improvements in production yield of semiconductor devices. Further, when a metallic wiring layer after dry-etched is evaluated for chemical and physical properties, the results of evaluation on the dry-etching and post-processings can be feedbacked in the wiring forming process.

(Second Embodiment)

With reference to Figs. 11 and 12, the following description will discuss a metal surface state evaluation method according to a second embodiment of the present invention and a measurement apparatus to be used in the method above-mentioned.

Fig. 11 shows a general arrangement of the measurement apparatus capable of measuring the potential of a very small region in the metal surface state evaluation method according to the second embodiment of the present invention. Fig. 12 shows in detail the measurement apparatus in Fig. 11.

Shown in Figs. 11 and 12 are a galvanostat 41 for measuring an electrode potential at a constant electric current, a recorder 42 for recording changes in potential with the passage of time, and a semiconductor wafer 43 on which deposited is a sample to be measured or an Al alloy layer serving as the metallic wiring layer. Also shown in Figs. 11 and 12 are a reference electrode 44 made of Ag/AgCl, a counter electrode 45 made of Pt, a first container 46 to be filled with a first solution 48 such as a HCl solution or the like, and a second container 47 to be filled with a second solution 49 such as a NaCl solution, KCl solution or the like. A crosslinking portion 50 made of a porous body such as Vycor glass or the like, prevents an exchange of the first solution 48 for the second solution 49.

The reference electrode 44, the counter electrode 45 and the first container 46 are made in a unitary structure. The first container 46 is made of a cylindrical body having a diameter of about 1 cm and a height of about 3 cm. The first container 46 is made of a material, such as glass, fluorocarbon or the like, which is not reactive to the first solution 48 and which prevents the first solution 48 from percolating to the outside.

Metal will be evaluated for surface state using the measurement apparatus having the arrangement above-mentioned in the following manner.

First, a very small region to be evaluated on the semiconductor wafer 43 is brought to close contact with the lower end of the first container 46, and the first container 46 is filled with the first solution 48.

Then, a constant current is applied to the counter electrode 45, a sample to be measured or a metallic wiring layer is subjected to constant-current electrolysis, and the electrode potential of the metallic wiring layer is measured.

Then, to measure the electrode potential of another very small region on the semiconductor wafer 43, the inside of the first container 46 is cleaned, the first solution 48 is replaced with new one, a constant electric current is applied to the counter electrode 45 in another very small region on the semiconductor wafer 43 and the electrode potential of the metallic wiring layer on another very small region is measured. Based on the electrode potential thus measured, there are calculated the ratio of changes in time of pitting corrosion to changes in current value and the critical current value, based on which the metal surface is evaluated.

According to the evaluation method above-mentioned, the metallic wiring layer on the semiconductor wafer 43 can be monitored at a plurality of points thereof in a short period of time without the semiconductor wafer 43 being broken.

According to the second embodiment, the semiconductor wafer 43 can be monitored at a plurality of very small regions thereof using the evaluation method above-mentioned and the measurement apparatus above-mentioned. It is therefore possible to check variations of the metal surface state within a plane of the semiconductor wafer 43 and to obtain the average of such variations. Thus, the surface state of the metallic wiring layer on the semiconductor wafer 43 can more accurately be evaluated in a short period of time without the semiconductor wafer 43 being broken.

With reference to Fig. 13, the following description will discuss a semiconductor device production method.

Fig. 13 is a flow chart illustrating the steps to be carried out when the metal surface state evaluation method according to each of the first and second embodiments of the present invention is applied to a semiconductor device production process.

In the semiconductor device production process, $O_2$ ashing is conducted to remove a resist after dry-etching as a wiring forming step, and a nitric acid and hydrofluoric acid mixed solution cleaning treatment is then conducted for cleaning the semiconductor wafer to restrain the metallic thin layer as a wiring layer from being corroded by residual chlorine ions. The nitric acid and hydrofluoric acid mixed solution cleaning treatment causes an oxide layer to be formed on the metallic wiring layer to prevent the same from being corroded.

After the nitric acid and hydrofluoric acid mixed solution cleaning treatment, the metal surface state evaluation method according to each of the first and second embodiments is utilized at an evaluation step of evaluating the pitting corrosion resistance of the oxide layer formed on the metallic wiring layer after cleaned using nitric acid and hydrofluoric acid mixed solution, the corrosion resistance of the metal or the segregation amount of contained trace metal. At the evaluation step, it can be judged whether or not the evaluation items meet standard requirements, and each semiconductor wafer below standards is selected. Then, such a semiconductor wafer below standards is, for example, oxidized again by a nitric acid and hydrofluoric acid mixed solution treatment to increase the thickness of the surface layer such that the pitting corrosion resistance is increased until the semiconductor wafer meets standard requirements. This greatly contributes to improvements in production yield of semiconductor devices.

The following description will discuss a further semiconductor device production method.

To determine the conditions of depositing a metallic wiring layer in a semiconductor device production process, the metal surface state evaluation method according to each of the first and second embodiments is applied immediately after the metallic wiring layer has been deposited. More specifically, a metallic wiring layer immediately after deposited on the semiconductor wafer, is subjected to constant-current electrolysis, and there are measured the ratio of changes in time of pitting corrosion to changes in applied current value, and the critical current value.

Based on the ratio of changes and critical current values thus measured, the metallic wiring layer immediately after deposited can be evaluated for corrosion resistance and surface state in a short period of time. It is therefore possible to judge, in a short period of time, whether or not the metallic wiring layer deposit conditions are suitable.

The following description will discuss a method of selecting a surface activation treating solution in a plating process.

When plating a metal piece, it is required to perfectly remove an oxide layer on the metal surface to activate the metal surface before the metal is immersed in a plating solution. For selecting a surface activation treating solution to be used for such an activation, the metal surface state evaluation method according to the first embodiment is used.

Pieces to be plated having the same specifications are respectively immersed in a plurality of surface activation treating solutions and subjected to constant-current electrolysis according to the first embodiment under the same condition. Based on the relationship between current value and time of pitting corrosion, the dependency of time of pitting corrosion on current value is evaluated. It can be understood that, out of the plurality of surface activation treating solutions, the solution presenting the smallest dependency of time of pitting corrosion on current value or presenting the smallest slope of a graphic line showing changes in time of pitting corrosion with respect to current value, has the greatest ability of corroding the oxide layer on each piece to be plated. Accordingly, such a treating solution is selected as the best surface activation treating solution.

The following description will discuss a method of selecting a polishing solution in a semiconductor device wiring forming process.

The metal surface state evaluation method according to the first embodiment is applied for selecting a polishing solution with which a piece to be polished is polished in a chemical mechanical polishing method (CMP) used as an embedded groove flattening method in a semiconductor device wiring forming process.

Pieces to be polished having the same specifications are respectively immersed in a plurality of polishing solutions and subjected to constant-current electrolysis according to the first embodiment under the same condition. Based on the relationship between current value and time of pitting corrosion obtained by the constant-current electrolysis, the dependency of time of pitting corrosion on current value is evaluated. It can be understood that, out of the plurality of polishing solutions, the solution presenting the smallest dependency of time of pitting corrosion on current value or presenting the smallest slope of a graphic line showing changes in time of pitting corrosion with respect to current value, has the greatest ability of corroding the oxide layer on each piece to be polished. Accordingly, such a polishing solution is selected as the best polishing solution.

With reference to Figs. 14 and 15, the following description will discuss a method of electrically chemically evaluating the surface state of metal and a measurement apparatus to be used in this method.

Fig. 14 shows a schematic arrangement of the measurement apparatus to be used in the metal surface state evaluation method, while Fig. 15 shows in detail the same. This measurement apparatus is arranged to measure, at a constant potential in a solution, the corrosion current of an Al alloy layer which is a metallic wiring layer on a semiconductor wafer.

Shown in Figs. 14 and 15 are a potentiostat 61 for measuring a corrosion current, a recorder 62 for recording changes in corrosion current with the passage of time, and a semiconductor wafer 63 on which deposited is a sample to be measured or an Al alloy layer serving as the metallic wiring layer. Also shown in Figs. 14 and 15 are a reference electrode 64 made of Ag/AgCl, a counter electrode 65 made of Pt, and connection wiring lines 66, 67, 68 for respectively connecting the semiconductor wafer 63, the reference electrode 64 and the counter electrode 65 to the potentiostat 61. By immersing the semiconductor wafer 63, the reference electrode 64 and the counter electrode 65 in a measurement cell 69 filled with a solution, changes in corrosion current with the passage of time can be measured while applying a potential in the vicinity of a natural electrode potential to the sample to be measured. The potentiostat 61 reads the value of an electric current flowing between the counter electrode 65 and the semiconductor wafer 63 at the time when a potential is applied to the semiconductor wafer 63 from the potentiostat 61.

The natural electrode potential refers to a potential at which no electric current flows with the balance kept between an anode reaction in which metal dissolves, and a cathode reaction in which hydrogen ions in the solution are reduced to generate hydrogen. Even though a potential equal to the natural electrode potential is applied to the sample to be measured, no corrosion current flows. Unlike a polarization characteristic measurement method of measuring a corrosion current while sweeping a potential, the application of a potential in the vicinity of the natural electrode potential to a sample to be measured, makes it possible to observe the behavior of the sample under natural corrosion in the solution without the sample forcibly corroded.

Referring to Fig. 16, the following description will discuss a metal surface state evaluation method using the measurement apparatus having the arrangement above-mentioned.

Fig. 16 shows the results of changes in corrosion current with the passage of time, as obtained when an AlSiCu thin layer was subjected to constant-potential electrolysis in a 1N (normality)-hydrochloric acid (HCl) solution.

As the solution, a hydrochloric acid solution was used because chlorine ions are liable to corrode aluminum. However, a solution of hydrochloric acid is not necessarily required as far as the solution generates halogen ions.

From Fig. 16, there can be read a period of time before pitting corrosion starts (time of no pitting corrosion) and speed at which aluminum is corroding. In Fig. 16, a period of time during which the current density (current value) is constant after a potential has been applied, i.e., from 0 to $T_6$, is a time zone where no corrosion current is generated. In such a time zone, no pitting corrosion takes place in the aluminum oxide layer.

The current density (current value) is suddenly decreased at $T_6$ at which pitting corrosion starts occurring. The time zone from 0 to $T_6$ is time of no pitting corrosion. In a time zone (from $T_6$ to $T_7$) where, after suddenly dropped, the current density (current value) is increased to a value in the vicinity of a maximum current density (maximum current value $I_{max}$), pitting corrosion occurs in the surface layer of the AlSiCu thin layer. In a time zone (from $T_7$ to $T_8$) where, after increased to a value in the vicinity of the maximum current density (maximum current value $I_{max}$), the current density (current value) is maintained substantially at the maximum current density (maximum current value $I_{max}$), the AlSiCu thin layer is corroding.

As the time of no pitting corrosion is longer, the pitting corrosion resistance of the metal surface is greater, and as the maximum current value is smaller, the metal corrosion speed is smaller.

Thus, based on the changes, with the passage of time, in corrosion current measured by conducting constant-potential electrolysis in hydrochloric acid, the time of no pitting corrosion and maximum current value are measured. Then, the pitting corrosion resistance of the metal surface can be evaluated based on the time of no pitting corrosion, and the corrosion resistance of the metal can be evaluated based on the maximum current value.

A sample to be measured is subjected to constant-potential electrolysis in hydrochloric acid, a corrosion current is measured, changes in corrosion current with the passage of time are measured to obtain time of no pitting corrosion and maximum current value, and based on the time of no pitting corrosion and maximum current value thus obtained, the pitting corrosion resistance of the layer on the metal surface and the corrosion resistance of the metal can quantitatively be evaluated in an in-line manner in a short period of time without the semiconductor wafer broken.

Accordingly, the occurrence of corrosion in a wiring forming process can be monitored in an in-line manner in a short period of time without the semiconductor wafer broken, thus greatly contributing to improvements in production yield of semiconductor devices. Further, when a metallic wiring layer after dry-etched is evaluated, the results of evaluation on the dry-etching and post-processings can be feedbacked in the wiring forming process.

With reference to Figs. 17 and 18, the following description will discuss a metal surface state evaluation method according to a further embodiment of the present invention.

Fig. 17 shows a general arrangement of a measurement apparatus capable of measuring the electric current

of a very small region when evaluating metal for surface state, and Fig. 18 shows in detail the measurement apparatus.

Shown in Figs. 17 and 18 are a potentiostat 81 for measuring a corrosion current, a recorder 82 for recording changes in corrosion current with the passage of time, and a semiconductor wafer 83 on which deposited is a sample to be measured or an Al alloy layer serving as the metallic wiring layer. Also shown in Figs. 17 and 18 are a reference electrode 84 made of Ag/AgCl, a counter electrode 85 made of Pt, a first container 86 to be filled with a first solution 88 such as a HCl solution or the like, and a second container 87 to be filled with a second solution 89 such as a NaCl solution, KCl solution or the like. A crosslinking portion 90 made of a porous body such as Vycor glass or the like, prevents an exchange of the first solution 88 for the second solution 89.

The reference electrode 84, the counter electrode 85 and the first container 86 are made in a unitary structure. The first container 86 is a cylindrical body having a diameter of about 1 cm and a height of about 3 cm. The first container 86 is made of a material, such as glass, fluorocarbon or the like, which is not reactive to the first solution 88 and which prevents the first solution 88 from percolating to the outside.

The surface state of metal will be evaluated using the measurement apparatus having the arrangement above-mentioned in the following manner.

First, a very small region to be evaluated on the semiconductor wafer 83 is brought into close contact with the lower end of the first container 86, and the first container 86 is filled with the first solution 88.

Then, a constant potential is applied from the potentiostat 81 to the semiconductor wafer 83, a sample to be measured or a metallic wiring layer is subjected to constant-potential electrolysis, and the corrosion current of the metallic wiring layer is measured.

Then, to measure the corrosion current of another very small region on the semiconductor wafer 83, the inside of the first container 86 is cleaned and the first solution 88 is replaced with new one, a constant potential is applied to the first and second solutions 88, 89 in another very small region on the semiconductor wafer 83 and the corrosion current of the metallic wiring layer on another very small region is measured. Based on the corrosion current thus measured, the time of no pitting corrosion and the maximum current value (maximum current density) are measured to evaluate the metal surface state.

According to the evaluation method above-mentioned, the metallic wiring layer on the semiconductor wafer 83 can be monitored at a plurality of points thereof in a short period of time without the semiconductor wafer 83 broken.

According to this embodiment, the semiconductor wafer 83 can be monitored at a plurality of very small regions thereof using the evaluation method above-mentioned and the measurement apparatus above-mentioned. It is therefore possible to check variations of the metal surface state within a plane of the semiconductor wafer 83 and to obtain the average of such variations. Thus, the surface state of the metallic wiring layer on the semiconductor wafer 83 can more accurately be evaluated in a short period of time without the semiconductor wafer 83 broken.

With reference to Fig. 13, the following description will discuss a semiconductor device production method according to another embodiment of the present invention.

Fig. 13 is a flow chart illustrating the steps to be carried out when the metal surface state evaluation method is applied to a semiconductor device production process.

In the semiconductor device production process, $O_2$ ashing is conducted to remove a resist after dry-etching in a wiring forming step, and a nitric acid and hydrofluoric acid mixed solution cleaning treatment is then conducted for cleaning the semiconductor wafer to restrain the metallic thin layer as a wiring layer from being corroded by residual chlorine ions. The nitric acid and hydrofluoric acid mixed solution cleaning treatment causes an oxide layer to be formed on the metallic wiring layer to prevent the same from being corroded.

After the nitric acid and hydrofluoric acid mixed solution cleaning treatment, the metal surface state evaluation method is utilized at an evaluation step of evaluating the pitting corrosion resistance of the oxide layer formed on the metallic wiring layer after cleaned using nitric acid and hydrofluoric acid mixed solution, the corrosion resistance of the metal or the segregation amount of contained trace metal. At the evaluation step, it can be judged whether or not the evaluation items meet standard requirements, and each semiconductor wafer below standards is selected. Then, such a semiconductor wafer below standards is, for example, oxidized again by a nitric acid and hydrofluoric acid mixed solution treatment to increase the thickness of the surface layer such that the layer is increased in the pitting corrosion resistance until the semiconductor wafer meets standard requirements. This greatly contributes to improvements in production yield of semiconductor devices.

The following description will discuss a further semiconductor device production method.

To determine the conditions of depositing a metallic wiring layer in a semiconductor device production process, the metal surface state evaluation method is applied immediately after the metallic wiring layer has been deposited. More specifically, the metallic wiring layer immediately after deposited on the semiconductor wafer, is subjected to constant-potential electrolysis and the time of no pitting corrosion and maximum current value are measured based on the corrosion current.

Based on the time of no pitting corrosion and maximum current value thus measured, the metallic wiring layer immediately after deposited can be evaluated for the pitting corrosion resistance of the surface layer and corrosion

resistance of the metal in a short period of time. It is therefore possible to judge, in a short period of time, whether or not the metallic wiring layer deposit conditions are suitable.

The following description will discuss a method of selecting a polishing solution in a semiconductor device wiring forming process.

The metal surface state evaluation method is applied for selecting a polishing solution with which a piece to be polished is polished in a chemical mechanical polishing method (CMP) used as an embedded groove flattening method in a semiconductor device wiring forming process.

Pieces to be polished having the same specifications are respectively immersed in a plurality of polishing solutions and subjected to constant-potential electrolysis according to the seventh embodiment under the same conditions. Based on changes in corrosion current obtained by the constant-potential electrolysis, the solution presenting the most suitable corrosion speed, is selected as the best polishing solution.

In each of the embodiments above-mentioned, as the reference electrode, an Ag/AgCl electrode is used but the reference electrode is not limited to such an Ag/AgCl electrode. Further, an AlSiCu thin layer or AlCu thin layer is used as a sample to be measured, but the sample to be measured is not limited to such a layer. As far as the sample to be measured is a metallic thin layer, measurement can be made.

In the embodiments above-mentioned, the present invention is applied to the field of semiconductor device production, but it may also be applied to the field of production or mounting of a liquid crystal display device.

## Claims

1. Metal surface state evaluation method comprising the steps:

    a solution contacting step of bringing a metal surface into contact with a solution containing ions to corrode said metal surface;

    a metal corroding step of applying, to said solution, each of a plurality of constant electric currents respectively having different current values, causing said metal surface to be corroded by said solution;

    an electrode potential measuring step of measuring, at each of said electric currents, the electrode potential of said metal surface which is being corroded by said solution;

    a change ratio calculating step of calculating, based on said electrode potential at each of said electric currents, a ratio of changes in time of pitting corrosion to changes in current value; and

    a dissolving speed measuring step of measuring, based on said change ratio, a speed at which an oxide layer formed on the surface of said metal is dissolved, thereby evaluating the smoothness and/or pitting corrosion resistance of said metal surface.

2. Metal surface state evaluation method according to claim 1, further comprising the steps:

    a pitting-corrosion time calculating step of calculating, based on said electrode potential at each of said current values, a relationship between current value and time of pitting corrosion;

    a critical current value calculating step of calculating, based on said relationship between current value and time of pitting corrosion, a critical current value which is the minimum current value at which pitting corrosion starts occurring; and

    a pitting-corrosion property evaluating step of evaluating the pitting corrosion property of said metal surface based on said critical current value and the change ratio.

3. Metal surface state evaluation method according to claim 2, further comprising a grain size or grain boundary length evaluating step of evaluating the grain size or grain boundary length of said metal surface based on said critical current value calculated at said critical current value calculating step.

4. Metal surface state evaluation method according to any of claims 1-3, wherein the method is conducted in an in-line manner.

5. Metal surface state evaluation method according to any of claims 1-4, wherein a galvanostat (11) is used for measuring a natural electrode potential and a reference electrode (14), a counter electrode (15) and the metal surface to be measured are immersed in a solution and electrically connected with the galvanostat (11).

6. Metal surface state evaluation method according to claim 5, wherein electric current flows from the galvanostat (11) to the metal surface through the counter electrode (15) wherein the galvanostat (11) reads a difference in potential between the reference electrode (14) and the metal surface.

7. Method surface state evaluation method according to any of claims 1-6, wherein an Al alloy layer on a semiconductor wafer (13) is used as metal surface.

**Patentansprüche**

1. Verfahren zum Bewerten des Zustandes einer Metalloberfläche, das die folgenden Schritte umfasst:

   einen Lösungs-Kontaktherstellungsschritt, bei dem eine Metalloberfläche mit einer Lösung in Kontakt gebracht wird, die Ionen enthält, um die Metalloberfläche zu korrodieren;

   einen Metallkorrosions-Schritt, bei dem an die Lösung jeder einer Vielzahl konstanter elektrischer Ströme angelegt wird, die jeweils verschiedene Stromwerte aufweisen, so dass die Metalloberfläche durch die Lösung korrodiert wird;

   einen Elektrodenpotenzial-Messschritt, bei dem bei jedem der elektrischen Ströme das Elektrodenpotenzial der Metalloberfläche gemessen wird, die von der Lösung korrodiert wird;

   einen Änderungsverhältnis-Berechnungsschritt, bei dem auf Basis des Elektrodenpotenzials bei jedem der elektrischen Ströme ein Verhältnis zeitlicher Änderungen von Lochkorrosion zu Änderungen des Stromwertes berechnet wird; und

   einen Auflösungsgeschwindigkeits-Messschritt, bei dem auf Basis des Änderungsverhältnisses eine Geschwindigkeit gemessen wird, mit der eine Oxidschicht, die auf der Oberfläche des Metalls ausgebildet ist, gelöst wird, um so die Glätte und/oder Lochkorrosionsbeständigkeit der Metalloberfläche zu bewerten.

2. Verfahren zum Bewerten des Zustandes einer Metalloberfläche nach Anspruch 1, dass des Weiteren die folgenden Schritte umfasst:

   einen Lochkorrosionszeit-Berechnungsschritt, bei dem auf Basis des Elektrodenpotenzials bei jedem der Stromwerte eine Beziehung zwischen Stromwert und Zeit der Lochkorrosion berechnet wird;

   einen Schritt zum Berechnen eines kritischen Stromwertes, bei dem auf Basis der Beziehung zwischen Stromwert und Zeit der Lochkorrosion ein kritischer Stromwert berechnet wird, der der minimale Stromwert ist, bei dem Lochkorrosion aufzutreten beginnt; und

   einen Lochkorrosionsverhalten-Bewertungsschritt, bei dem das Lochkorrosionsverhalten der Metalloberfläche auf Basis des kritischen Stromwertes und des Änderungsverhältnisses bewertet wird.

3. Verfahren zum Bewerten des Zustandes einer Metalloberfläche nach Anspruch 2, dass des Weiteren einen Korngrößen- bzw. Korngrenzenlängen-Bewertungsschritt umfasst, bei dem die Korngröße bzw. Korngrenzenlänge der Metalloberfläche auf Basis des kritischen Stromwertes bewertet wird, der beim Schritt des Berechnens eines kritischen Stromwertes berechnet wird.

4. Verfahren zum Bewerten des Zustandes einer Metalloberfläche nach einem der Ansprüche 1-3, wobei das Verfahren fließend durchgeführt wird.

5. Verfahren zum Bewerten des Zustandes einer Metalloberfläche nach einem der Ansprüche 1-4, wobei ein Galvanostat (11) zum Messen eines Elektroden-Eigenpotenzials verwendet wird, und eine Bezugselektrode (14), eine Gegenelektrode (15) sowie die zu messende Metalloberfläche in eine Lösung eingetaucht und elektrisch mit dem

Galvanostat (11) verbunden sind.

6. Verfahren zum Bewerten des Zustandes einer Metalloberfläche nach Anspruch 5, wobei elektrischer Strom von dem Galvanostat (11) zu der Metalloberfläche durch die Gegenelektrode (15) fließt und der Galvanostat (11) eine Potenzialdifferenz zwischen der Bezugselektrode (14) und der Metalloberfläche misst.

7. Verfahren zum Bewerten des Zustandes einer Metalloberfläche nach einem der Ansprüche 1-6, wobei eine Al-Legierungsschicht auf einem Halbleiter-Wafer (13) als Metalloberfläche verwendet wird.

**Revendications**

1. Méthode d'évaluation de l'état de surface d'un métal comprenant les étapes suivantes :

   une étape de mise en contact d'une solution consistant à amener une surface de métal en contact avec une solution contenant des ions pour corroder ladite surface de métal,
   une étape de corrosion du métal consistant à appliquer, à ladite solution, chacun d'une pluralité de courants électriques constants présentant respectivement des valeurs de courant différentes, amenant ladite surface de métal à être corrodée par ladite solution,
   une étape de mesure de potentiel d'électrode consistant à mesurer, pour chacun desdits courants électriques, le potentiel d'électrode de ladite surface de métal qui est corrodée par ladite solution,
   une étape de calcul de taux de variation consistant à calculer, sur la base dudit potentiel d'électrode pour chacun desdits courants électriques, un taux des variations dans le temps de la corrosion par piqûres par rapport aux variations de la valeur du courant, et
   une étape de mesure de la vitesse de dissolution consistant à mesurer, sur la base dudit taux de variation, une vitesse à laquelle une couche d'oxyde formée à la surface dudit métal est dissoute, évaluant ainsi le lissé et/ou la résistance à la corrosion par piqûres de ladite surface de métal.

2. Méthode d'évaluation de l'état de surface d'un métal selon la revendication 1, comprenant en outre les étapes suivantes :

   une étape de calcul de l'instant de la corrosion par piqûres consistant à calculer, sur la base dudit potentiel d'électrode pour chacune desdites valeurs de courant, une relation entre la valeur du courant et l'instant de la corrosion par piqûres,
   une étape de calcul de valeur de courant critique consistant à calculer, sur la base de ladite relation entre la valeur du courant et l'instant de la corrosion par piqûres, une valeur de courant critique qui est la valeur de courant minimum à laquelle une corrosion par piqûres commence à apparaître, et
   une étape d'évaluation de propriété de corrosion par piqûres consistant à évaluer la propriété de corrosion par piqûres de ladite surface de métal sur la base de ladite valeur de courant critique et du taux de variation.

3. Méthode d'évaluation de l'état de surface d'un métal selon la revendication 2, comprenant en outre une étape d'évaluation de taille des grains et de longueur de limites des grains consistant à évaluer la taille des grains ou la longueur de limites des grains de ladite surface de métal sur la base de ladite valeur de courant critique calculée à ladite étape de calcul de valeur de courant critique.

4. Méthode d'évaluation de l'état de surface d'un métal selon l'une quelconque des revendications 1 à 3, dans laquelle la méthode est exécutée d'une manière en ligne.

5. Méthode d'évaluation de l'état de surface d'un métal selon l'une quelconque des revendications 1 à 4, dans laquelle un galvanostat (11) est utilisé pour mesurer un potentiel d'électrode naturel et une électrode de référence (14), une contre-électrode (15) et la surface de métal à mesurer sont immergés dans une solution et sont électriquement reliés au galvanostat (11).

6. Méthode d'évaluation de l'état de surface d'un métal selon la revendication 5, dans laquelle un courant électrique circule du galvanostat (11) à la surface du métal par la contre-électrode (15), dans laquelle le galvanostat (11) lit une différence de potentiel entre l'électrode de référence (14) et la surface du métal.

7. Méthode d'évaluation de l'état de surface d'un métal selon l'une quelconque des revendications 1 à 6, dans laquelle

une couche d'alliage de A1 sur une tranche de semiconducteur (13) est utilisée en tant que surface de métal.

Fig. 1

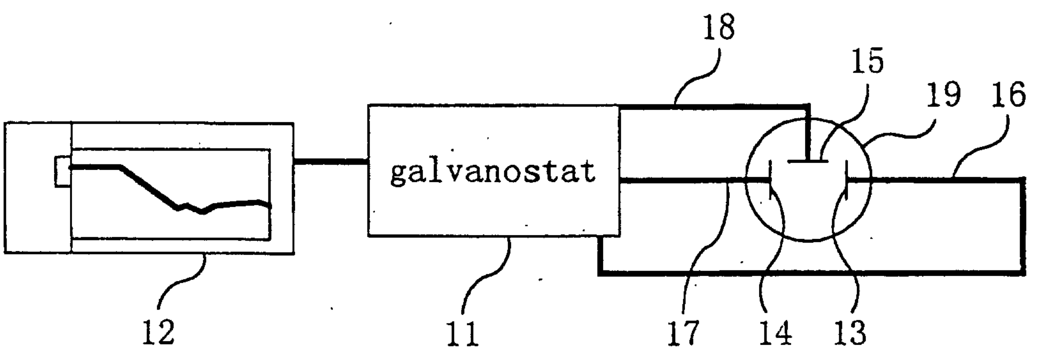

Fig. 2

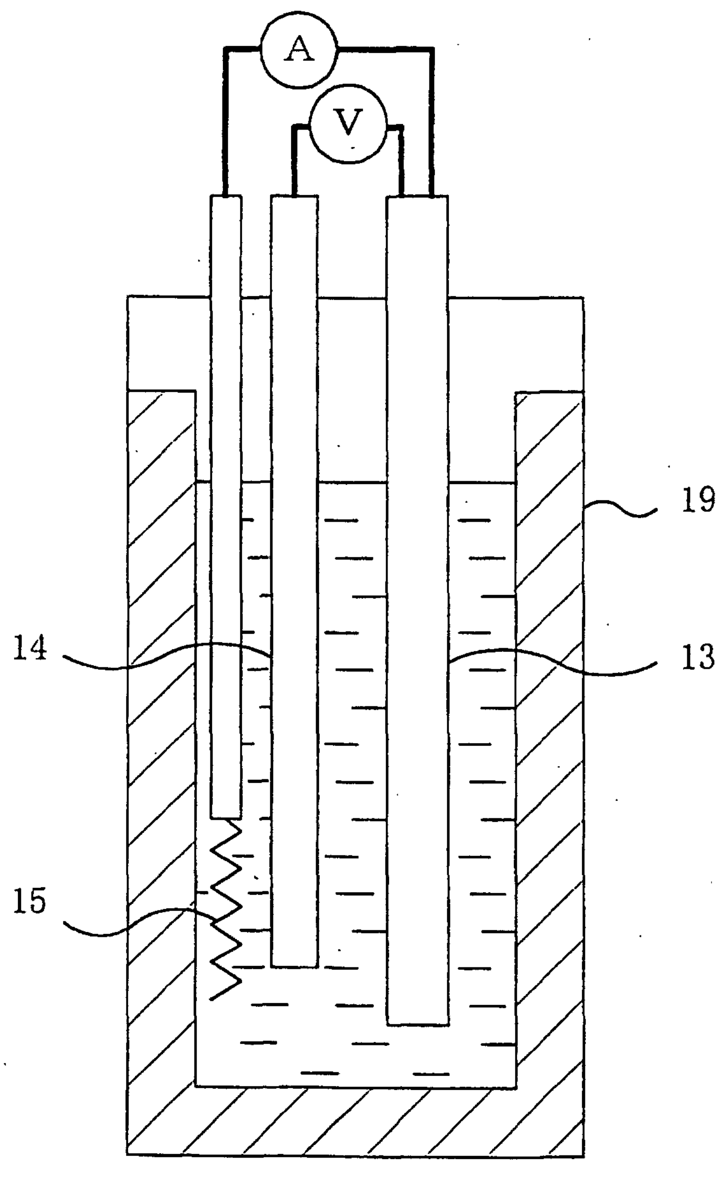

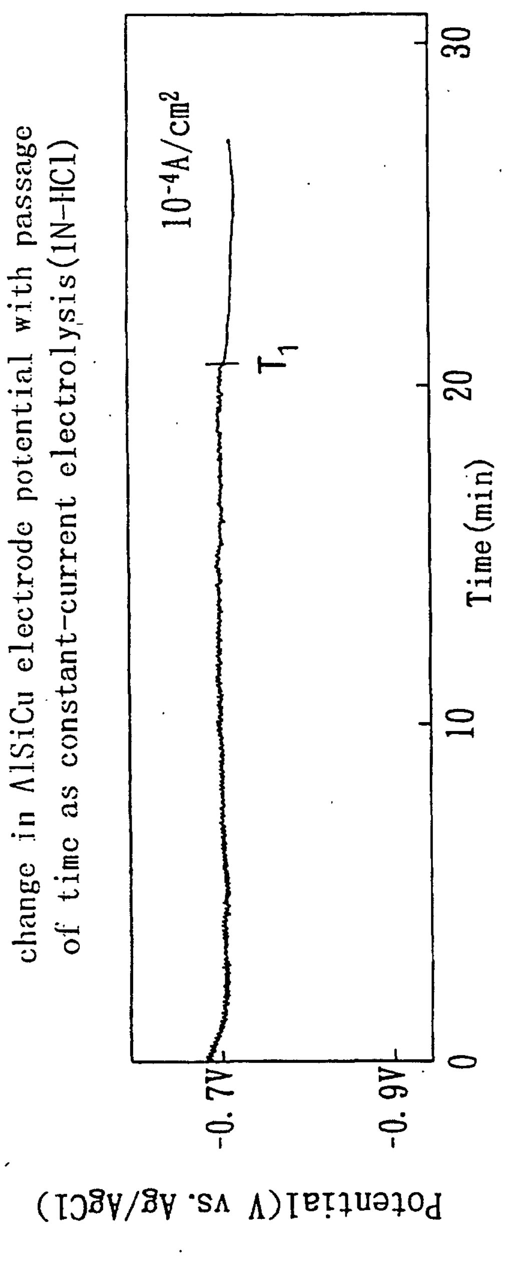
change in AlSiCu electrode potential with passage of time as constant-current electrolysis(1N-HCl)
$10^{-4}$A/cm$^2$
$T_1$
Potential(V vs. Ag/AgCl)
-0.7V
-0.9V
0
10
20
30
Time (min)

Fig. 3(a)

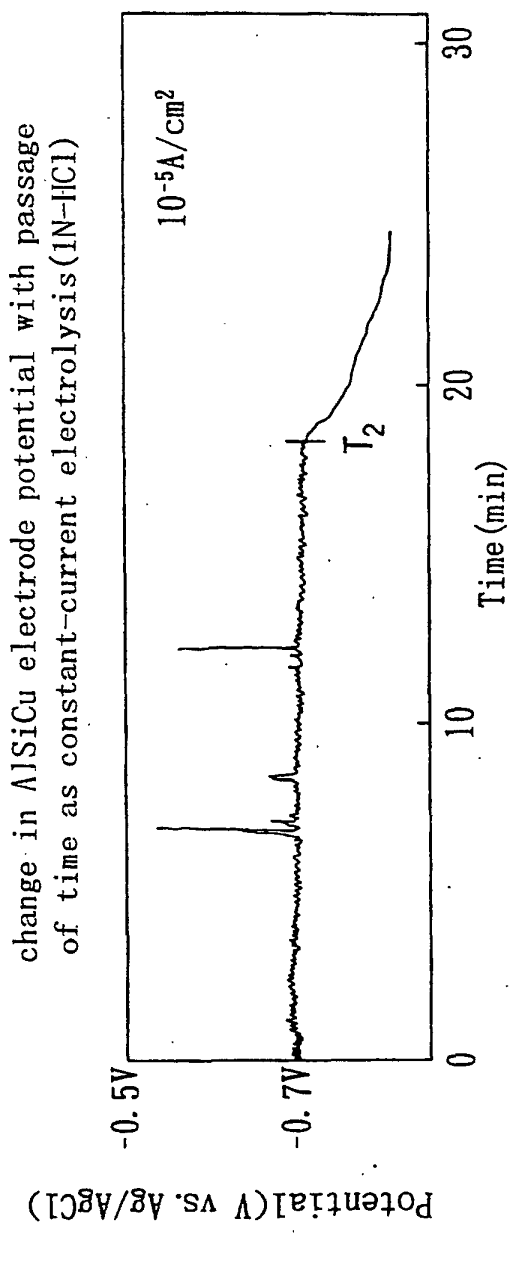
change in AlSiCu electrode potential with passage of time as constant-current electrolysis(1N-HCl)
$10^{-5}$A/cm$^2$
$T_2$
Potential(V vs. Ag/AgCl)
-0.5V
-0.7V
0
10
20
30
Time (min)

Fig. 3(b)

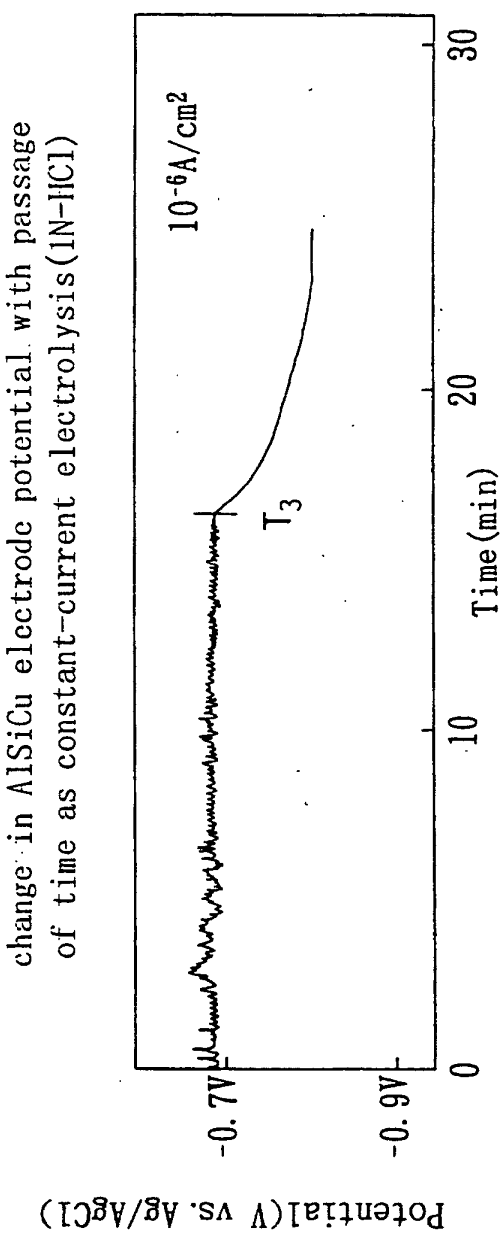
change in AlSiCu electrode potential with passage
of time as constant-current electrolysis(1N-HCl)
$10^{-6}A/cm^2$
$T_3$
-0.7V
-0.9V
0
10
20
30
Time(min)
Potential(V vs. Ag/AgCl)

Fig. 4(a)

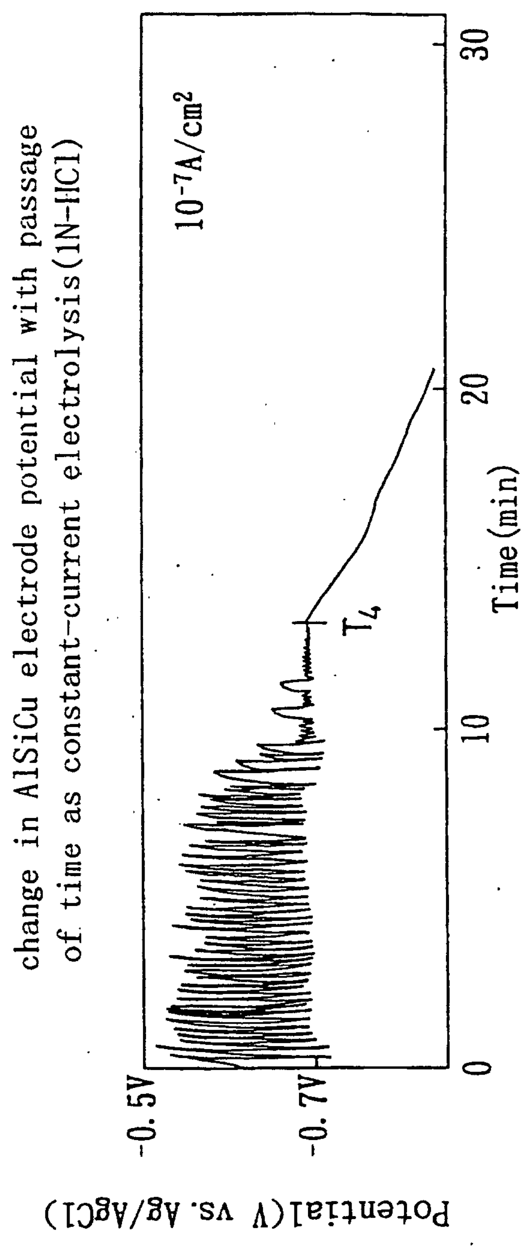
change in AlSiCu electrode potential with passage
of time as constant-current electrolysis(1N-HCl)
$10^{-7}A/cm^2$
$T_4$
-0.5V
-0.7V
0
10
20
30
Time(min)
Potential(V vs. Ag/AgCl)

Fig. 4(b)

FIG. 5

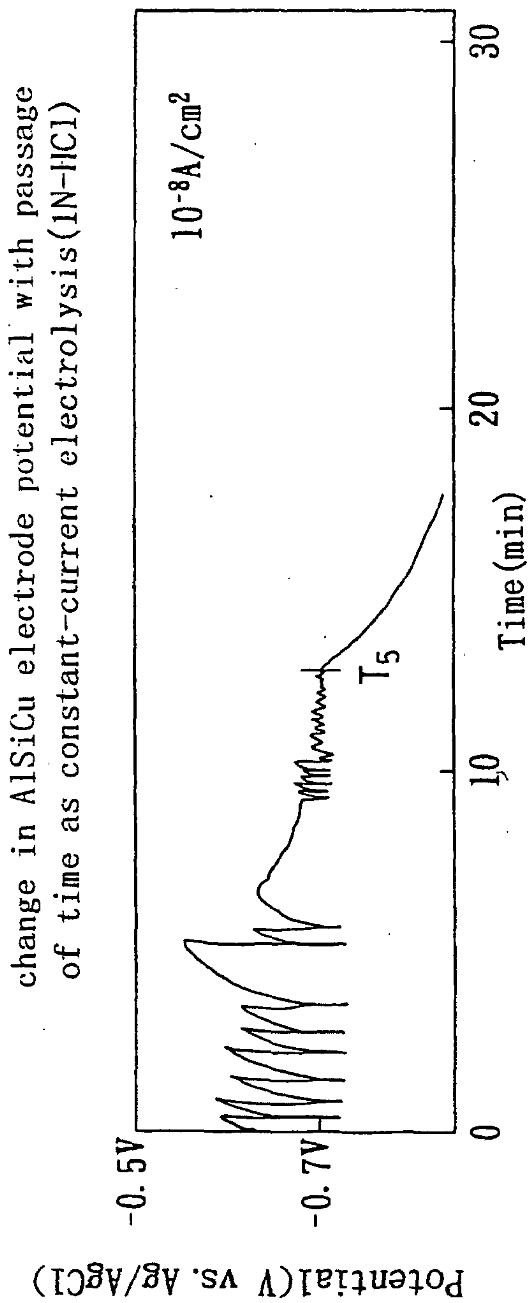
change in AlSiCu electrode potential with passage of time as constant-current electrolysis(1N-HCl)
$10^{-8}A/cm^2$
$T_5$
-0.5V
-0.7V
Potential(V vs. Ag/AgCl)
0
10
20
30
Time(min)

Fig. 6

□ immediately after sputtering 0.1N-hydoro chlonic acid

○ immediately after sputtering 1N-hydoro chlonic acid

△ immediately after sputtering 2N-hydoro chlonic acid

■ after heat treatment(450℃, 5min) 0.1N-hydoro chlonic acid

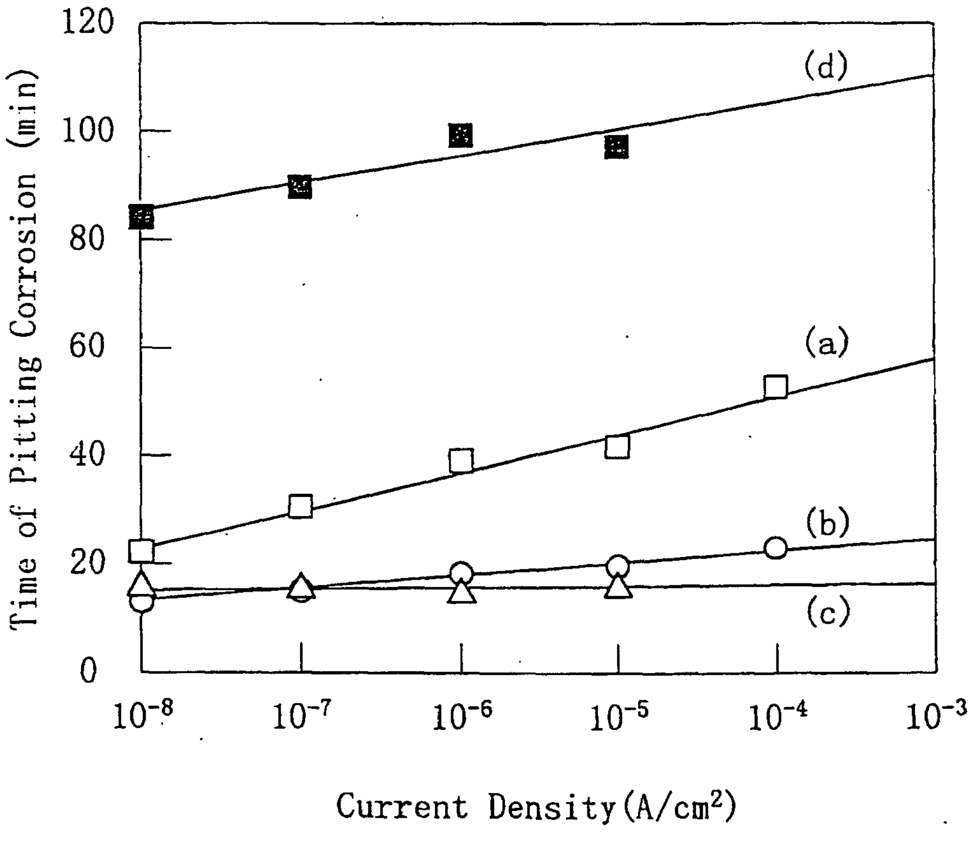

Fig. 7(a)

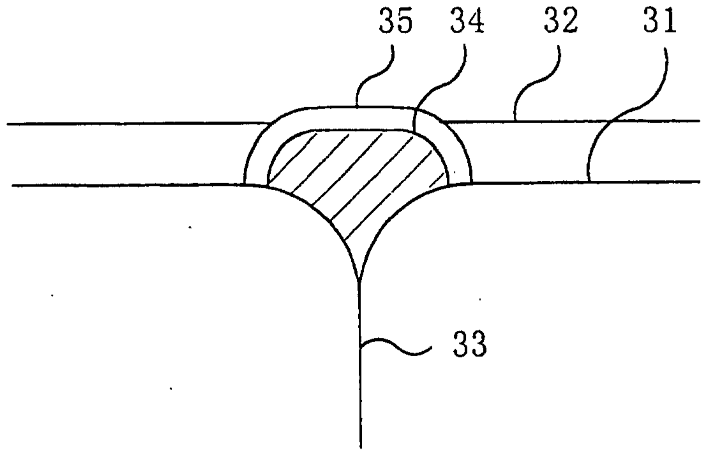


Fig. 7(b)

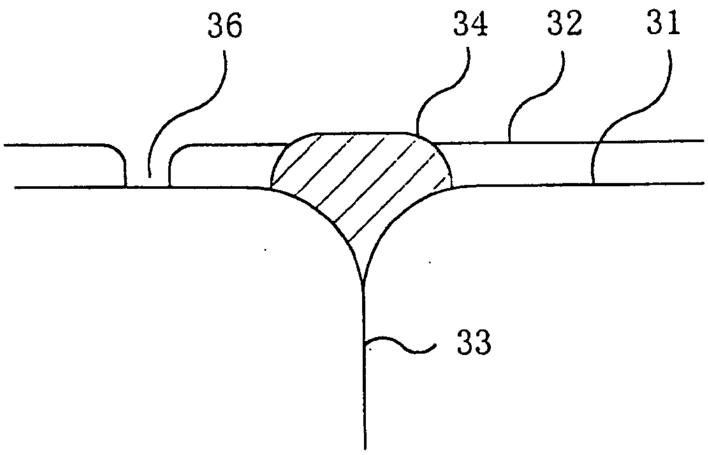

Fig. 8

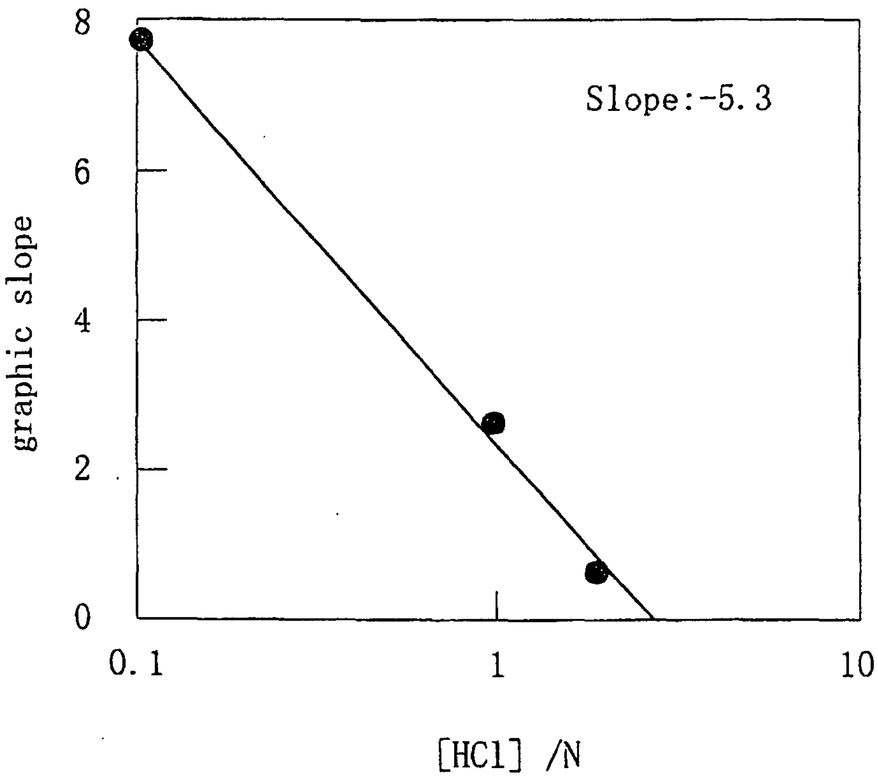

Fig. 9

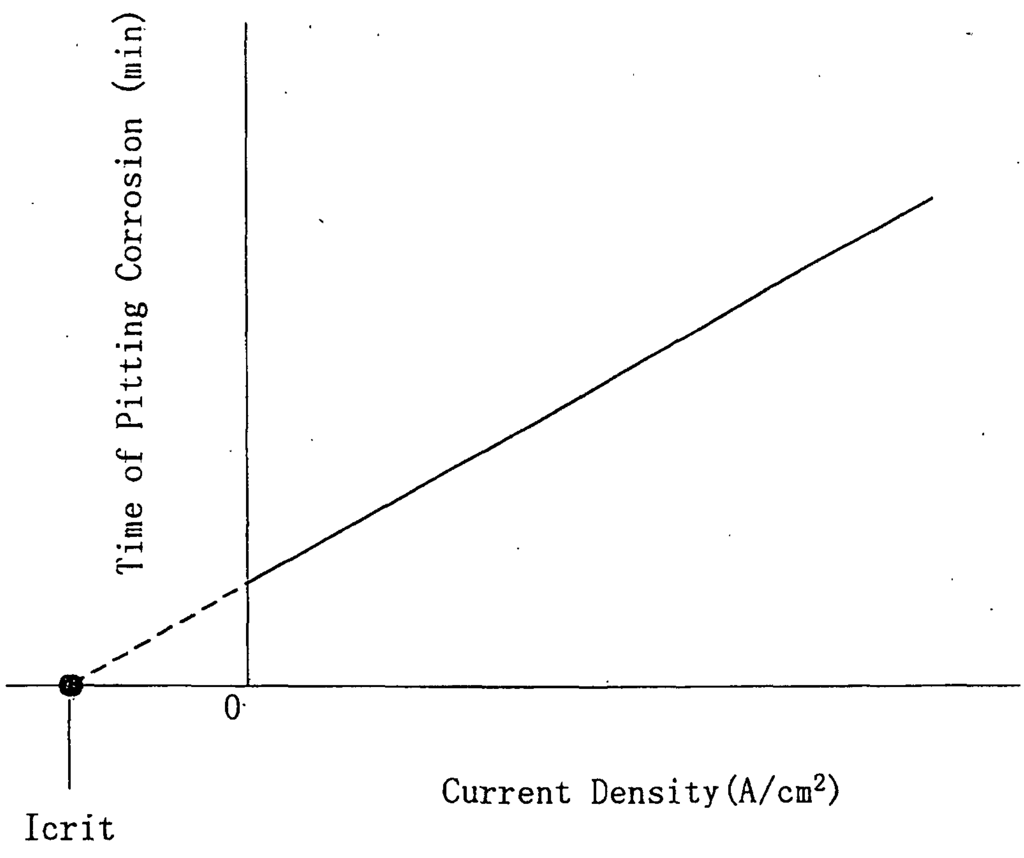

Fig. 10

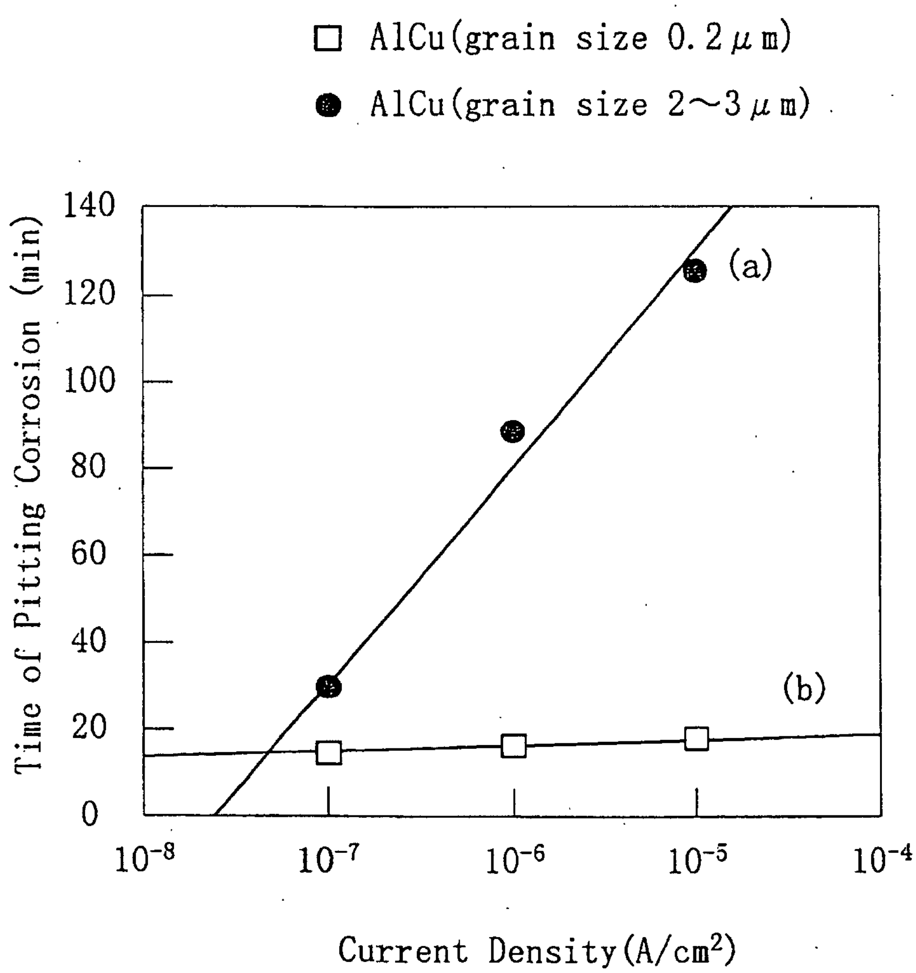
AlCu(grain size 0.2 μm)
AlCu(grain size 2～3 μm)
Time of Pitting Corrosion (min)
140
120
100
80
60
40
20
0
(a)
(b)
10-8
10-7
10-6
10-5
10-4
Current Density(A/cm2)

Fig. 11

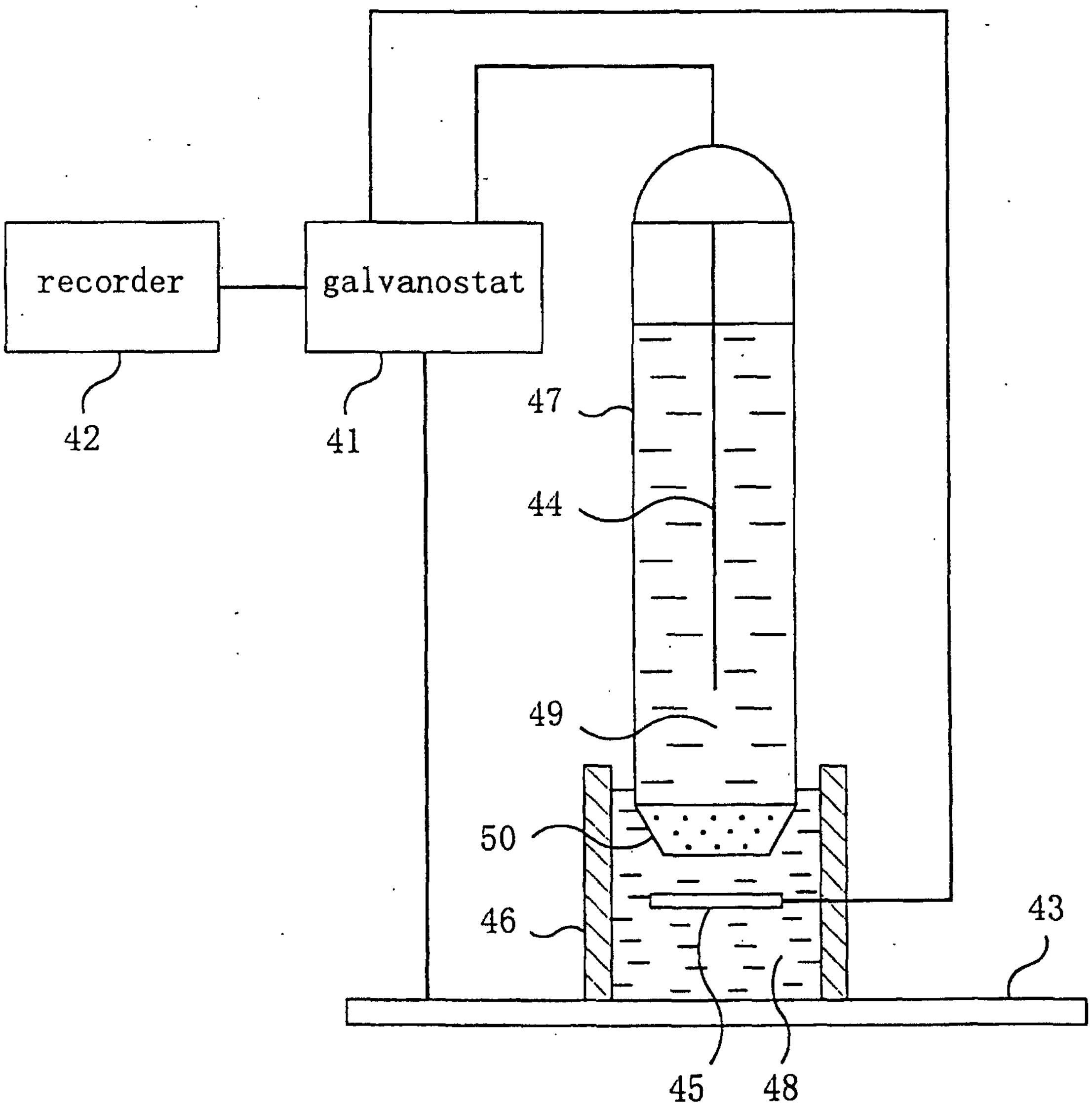

FIG. 12

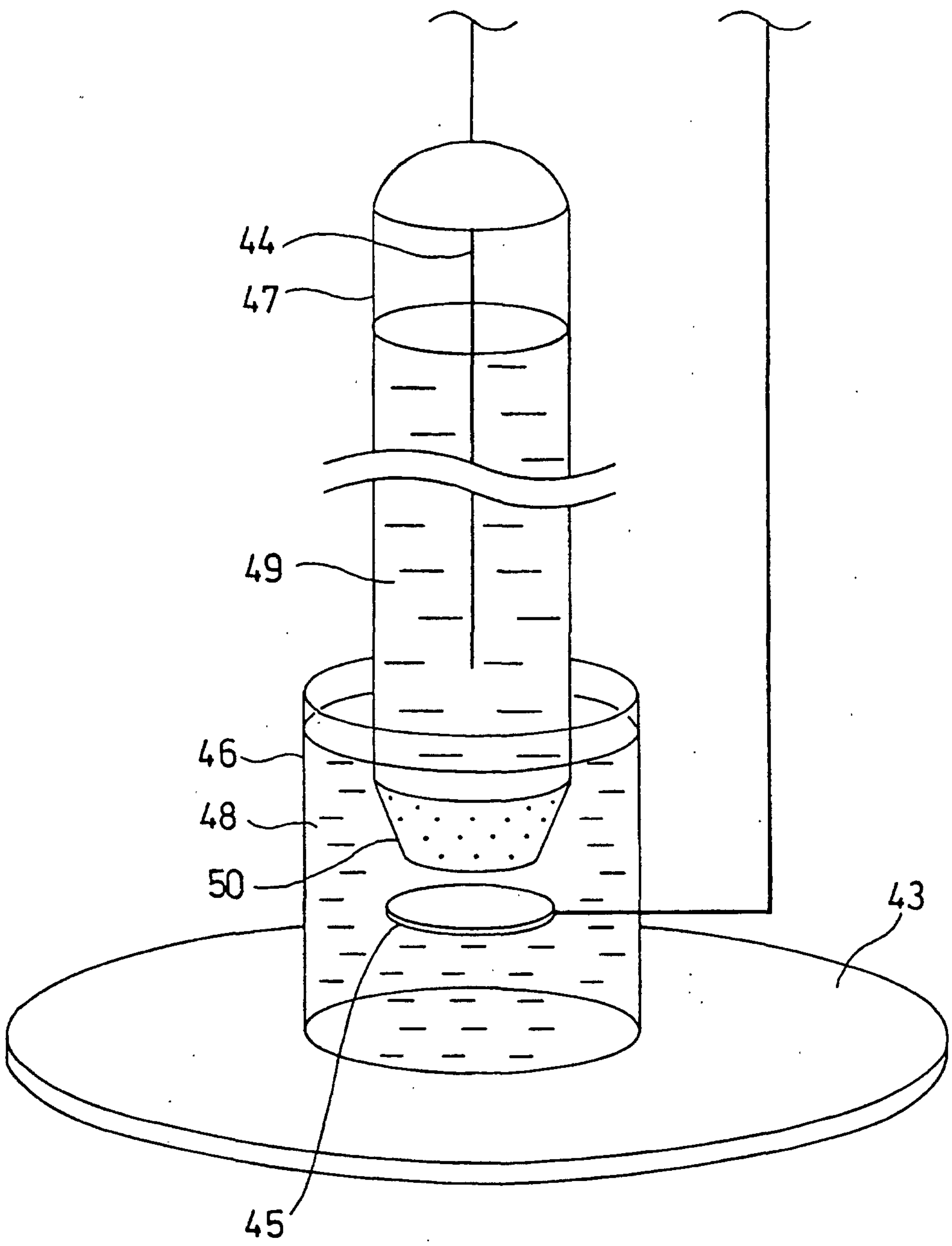

Fig. 13

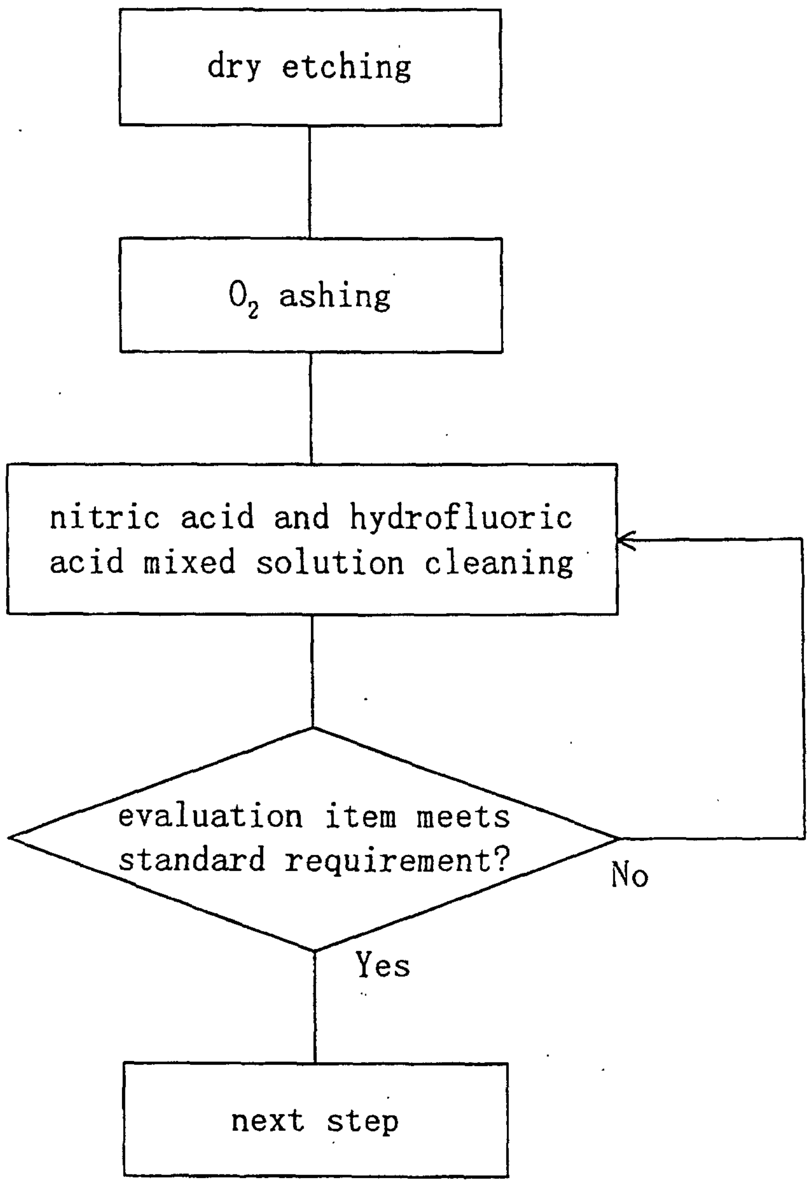
dry etching
$O_2$ ashing
nitric acid and hydrofluoric acid mixed solution cleaning
evaluation item meets standard requirement?
No
Yes
next step

Fig. 14

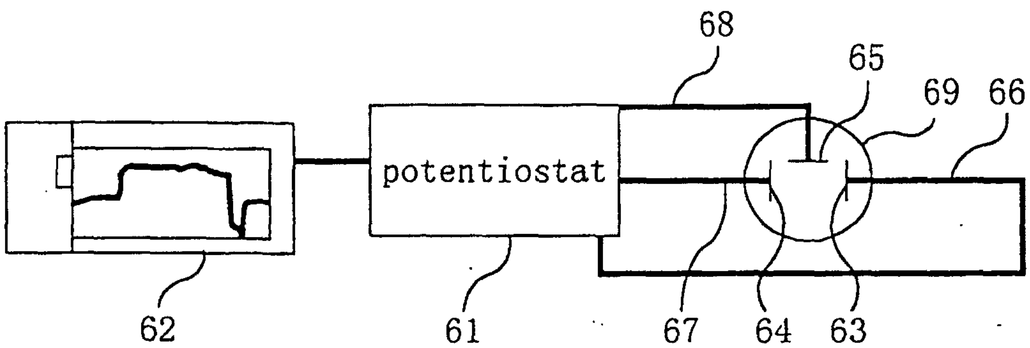

Fig. 15

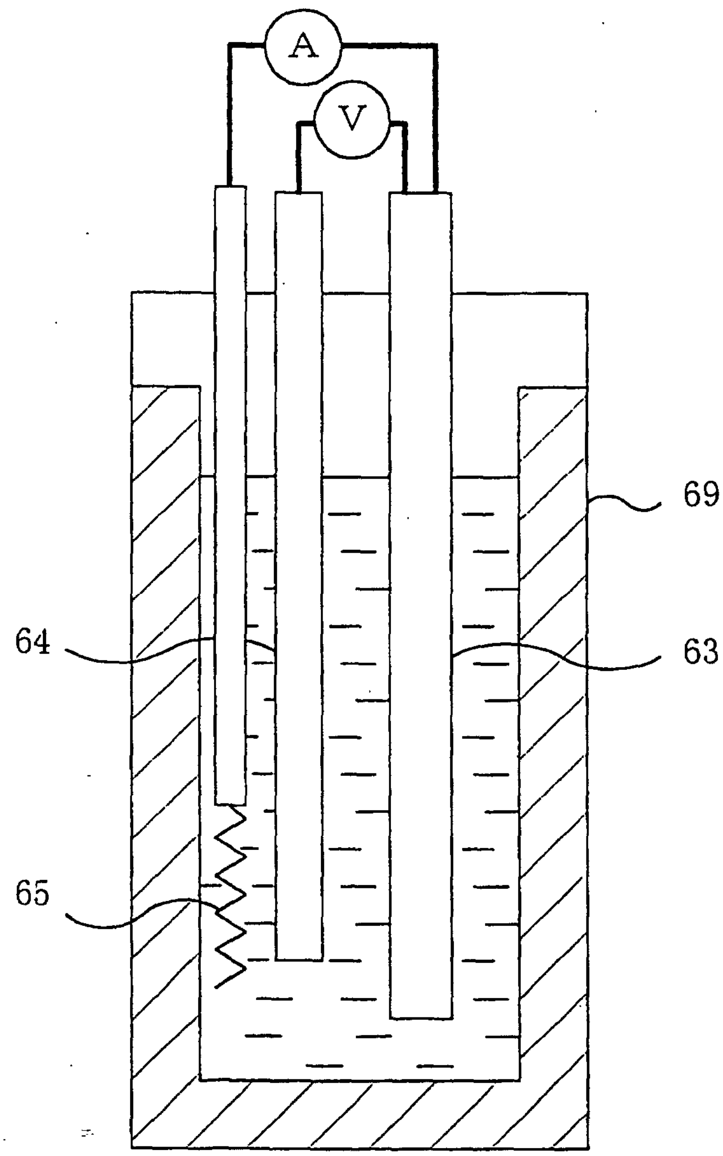

Fig. 16

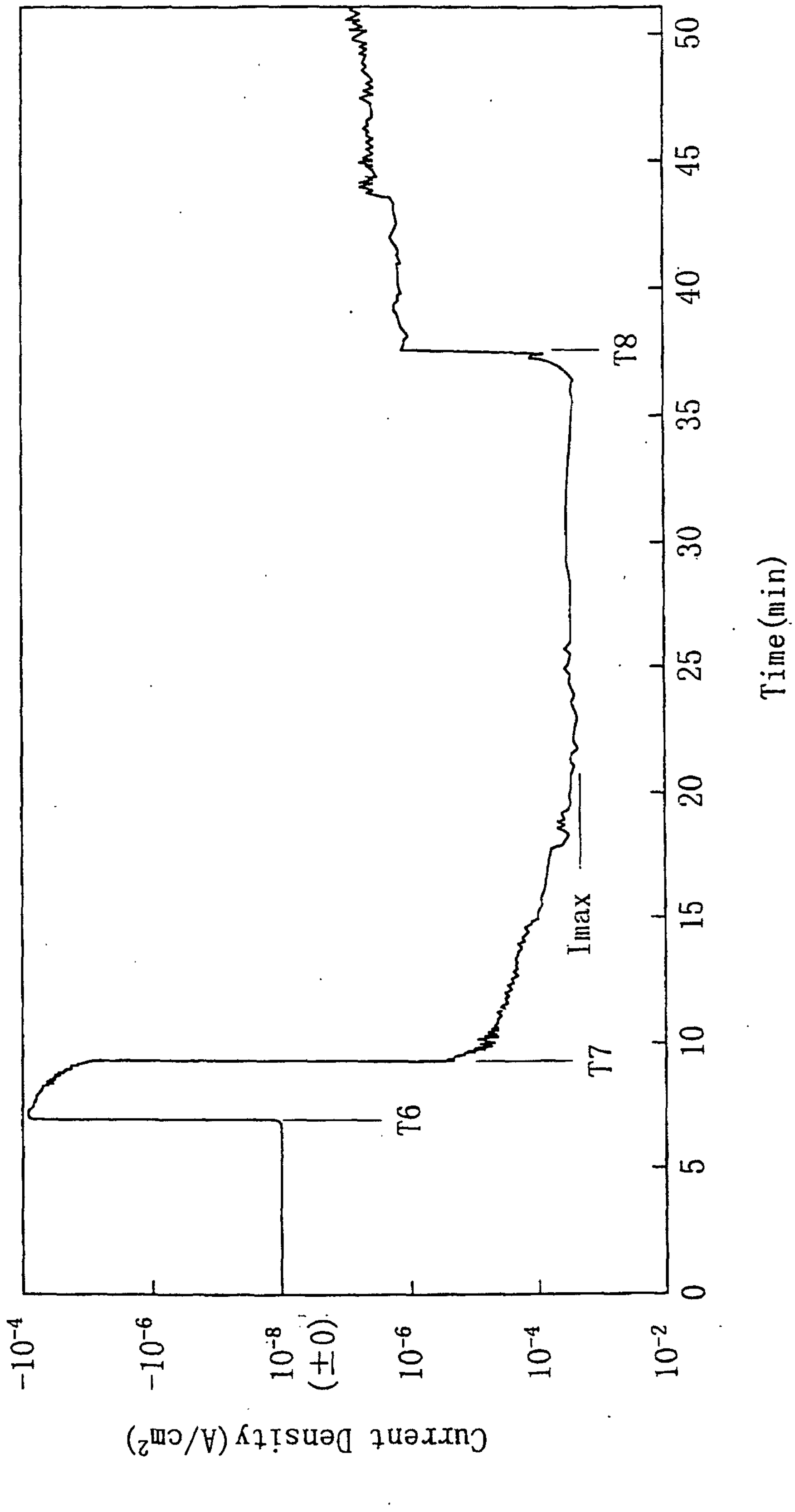
Current Density (A/cm²)
−10⁻⁴
−10⁻⁶
10⁻⁸ (±0)
10⁻⁶
10⁻⁴
10⁻²
Time (min)
0
5
10
15
20
25
30
35
40
45
50
T6
T7
T8
Imax

Fig. 17

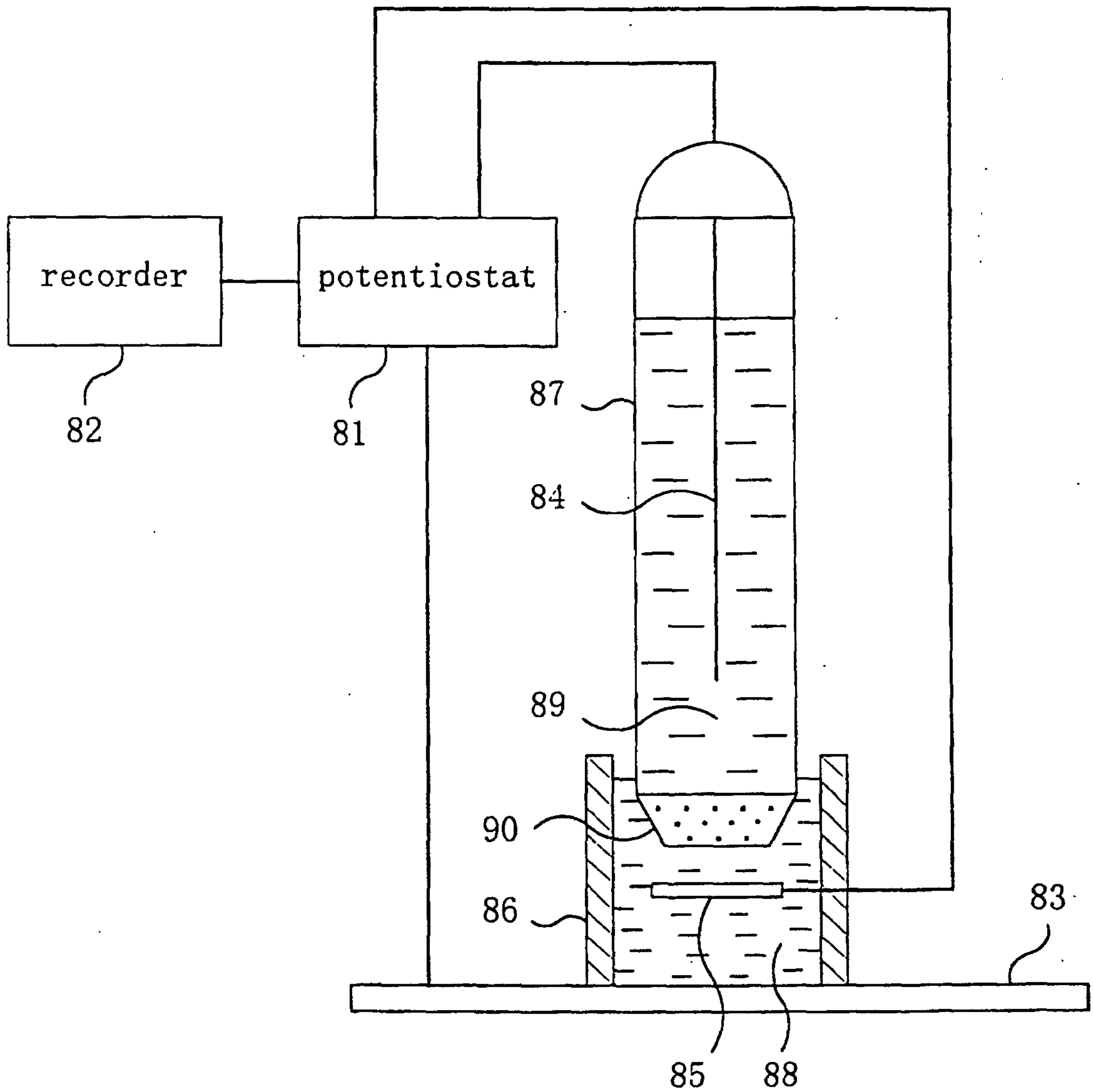

FIG. 18